# EUROPEAN PATENT APPLICATION

(11) **EP 4 716 198 A1**
(43) Date of publication of application: **25.03.2026**
(21) Application number: 24909584.5
(22) Date of filing: 13.06.2024
(51) Int. Cl.: H04M 1/02

(54) **FOLDING MECHANISM AND ELECTRONIC DEVICE**

(30) Priority: 29.12.2023 CN 202311867296
(71) Applicant: Huawei Technologies Co., Ltd., Shenzhen, Guangdong 518129 (CN)
(72) Inventor: LIN, Yangming, Shenzhen, Guangdong 518129 (CN); ZHANG, Haifeng, Shenzhen, Guangdong 518129 (CN); XIE, Kangzhou, Shenzhen, Guangdong 518129 (CN)
(74) Representative: Pfenning, Meinig & Partner mbB
(86) International application number: PCT/CN2024/098918
(87) International publication number: WO 2025/138622

(57) **Abstract**

This application provides a folding mechanism and an electronic device. The folding mechanism includes a main shaft, a first fastening bracket, a second fastening bracket, a first movable member, a second movable member, a first support plate, a second support plate, and a first elastic member. The first movable member connects the main shaft and the first fastening bracket, and the second movable member connects the main shaft and the second fastening bracket. The first support plate connects the first fastening bracket and the first movable member, and the second support plate connects the second fastening bracket and the second movable member. The first elastic member connects the first support plate and the first fastening bracket, and the first elastic member is in a compressed state. A first point of application of force is located on a side that is of a first rotation axis and that is away from the main shaft. When the folding mechanism is in a folded state, a first included angle formed between a first support surface and a connection line between the first point of application of force and a second point of application of force in a first direction is an acute angle. An end part that is of the first support plate and that is close to the main shaft expands in a direction away from the second support plate. A screen accommodating space enclosed by the first support plate, the main shaft, and the second support plate increases.

## Description

This application claims priority to Chinese Patent Application No. 202311867296.2, filed with the China National Intellectual Property Administration on December 29, 2023 and entitled "FOLDING MECHANISM AND ELECTRONIC DEVICE", which is incorporated herein by reference in its entirety.

### TECHNICAL FIELD

This application relates to the field of foldable electronic product technologies, and in particular, to a folding mechanism and an electronic device.

### BACKGROUND

With development of science and technology and requirements of an electronic device market, foldable electronic devices are increasingly widely used, and users have increasingly high requirements on overall refinements of the foldable electronic devices. The foldable electronic device includes a first housing, a second housing, a folding mechanism, and a flexible display. Due to an improper setting of a conventional folding mechanism, a bendable area of the flexible display is prone to damage after a period of use, and reliability of the flexible display is poor.

### SUMMARY

This application provides a folding mechanism that can improve reliability of a flexible display and an electronic device.

According to a first aspect, this application provides a folding mechanism. The folding mechanism includes a main shaft, a first fastening bracket, a second fastening bracket, a first movable member, a second movable member, a first support plate, a second support plate, and a first elastic member, where the main shaft is located between the first fastening bracket and the second fastening bracket. The first movable member movably connects the main shaft and the first fastening bracket, and the second movable member movably connects the main shaft and the second fastening bracket. The first support plate is rotatably connected to the first fastening bracket and movably connected to the first movable member, the second support plate is rotatably connected to the second fastening bracket and movably connected to the second movable member, when the folding mechanism is in an unfolded state, a first support surface of the main shaft, a second support surface of the first support plate, and a third support surface of the second support plate jointly form a support surface, and when the folding mechanism is in a folded state, the second support surface and the third support surface are disposed opposite to each other, and enclose at least a part of a screen accommodating space with the first support surface. The first elastic member connects the first support plate and the first fastening bracket, the first elastic member is in a compressed state, a point of application of force of the first elastic member on the first support plate is a first point of application of force, a point of application of force of the first elastic member on the first fastening bracket is a second point of application of force, and an axis of rotation of the first support plate relative to the first fastening bracket is a first rotation axis. The first point of application of force is located on a side that is of the first rotation axis and that is away from the main shaft, and when the folding mechanism is in a folded state, a first included angle formed between the first support surface and a connection line between the first point of application of force and the second point of application of force in a first direction is an acute angle, where the first direction is a direction in which the first support plate points to the second support plate.

It may be understood that when the folding mechanism is in a folded state, because the first elastic member is in a compressed state, the first elastic member may apply a first acting force to the first support plate. Because the first included angle formed between the first support surface and the connection line between the first point of application of force and the second point of application of force is an acute angle, the first acting force may generate a first component force in the first direction. In addition, because the first point of application of force is located on the side that is of the first rotation axis and that is away from the main shaft, the first component force may make an end part that is of the first support plate and that is away from the main shaft approach in a direction close to the second support plate. In this case, an acting force in the first direction may be formed on an end part that is of the first support plate and that is close to the main shaft. The end part that is of the first support plate and that is close to the main shaft may expand in a direction away from the second support plate. In this way, the screen accommodating space enclosed by the first support plate, the main shaft, and the second support plate can be greatly increased. When the folding mechanism is applied to an electronic device having a flexible display, and a second display area of the flexible display is located in the screen accommodating space, a free deformation space of the second display area of the flexible display is released, and a bending degree of the second display area of the flexible display may be small. In this case, the second display area of the flexible display is not prone to damage, and reliability of the flexible display is good. Particularly, when the electronic device is in an unconventional environment like suffering a fall or an impact, the folding mechanism is not prone to squeeze the flexible display, and the flexible display is not prone to failure or the like. In addition, when the end part that is of the first support plate and that is close to the main shaft expands in the direction away from the second support plate, the first support plate may also drive some parts of the folding mechanism to move slightly, to reduce a gap between some parts. In addition, the folding mechanism is more compact, and space utilization is higher.

In a possible implementation, a contact location between the first elastic member and the first support plate is located on the side that is of the first rotation axis and that is away from the main shaft.

It may be understood that the first point of application of force may be the center of the contact location between the first elastic member and the first support plate. In this way, when the contact location between the first elastic member and the first support plate is located on the side that is of the first rotation axis and that is away from the main shaft, it can be ensured that the first point of application of force is always located on the side that is of the first rotation axis and that is away from the main shaft. In this case, the first acting force applied by the first elastic member to the first support plate can always make the end part that is of the first support plate and that is away from the main shaft approach the direction close to the second support plate, and the end part that is of the first support plate and that is close to the main shaft can expand in the direction away from the second support plate.

In a possible implementation, the folding mechanism further includes a second elastic member, and the second elastic member connects the second support plate and the second fastening bracket. The second elastic member is in a compressed state, a point of application of force of the second elastic member on the second support plate is a third point of application of force, a point of application of force of the second elastic member on the second fastening bracket is a fourth point of application of force, and an axis of rotation of the second support plate relative to the second fastening bracket is a second rotation axis. The third point of application of force is located on a side that is of the second rotation axis and that is away from the main shaft, and when the folding mechanism is in a folded state, a second included angle formed between the first support surface and a connection line between the third point of application of force and the fourth point of application of force in a second direction is an acute angle, where the second direction is opposite to the first direction.

It may be understood that when the folding mechanism is in a folded state, because the second elastic member is in a compressed state, the second elastic member applies a second acting force to the second support plate. Because the second included angle formed between the first support surface and the connection line between the third point of application of force and the fourth point of application of force is an acute angle, the second acting force may generate a second component force in the second direction. In addition, because the third point of application of force is located on the side that is of the second rotation axis and that is away from the main shaft, the second component force may make an end part that is of the second support plate and that is away from the main shaft approach in a direction close to the first support plate. In this case, an acting force in the second direction may be formed on the end part that is of the second support plate and that is close to the main shaft, and the end part that is of the second support plate and that is close to the main shaft expands in a direction away from the first support plate. In this way, the screen accommodating space enclosed by the first support plate, the main shaft, and the second support plate can be further increased.

In a possible implementation, the first fastening bracket has a first guide block, the first support plate has a first mounting block, and the first mounting block is disposed opposite to the first guide block; and the first elastic member is a spring, one end of the first elastic member is sleeved on the first guide block and abuts against the first fastening bracket, and the other end of the first elastic member is sleeved on the first mounting block and abuts against the first support plate.

It may be understood that, when the folding mechanism is in a folded state, the first guide block of the first fastening bracket is disposed opposite to the first mounting block of the first support plate. In this way, the first guide block and the first mounting block can better guide a deformation direction of the first elastic member, to avoid damage to the first elastic member due to deformation. In another implementation, when the folding mechanism is in an unfolded state or any other state, the first guide block of the first fastening bracket may also be disposed opposite to the first mounting block of the first support plate. In this way, the first guide block and the first mounting block can always guide the deformation direction of the first elastic member, to avoid damage to the first elastic member due to deformation.

In a possible implementation, when the folding mechanism is in a folded state, the first mounting block may be at least partially located in the first mounting hole. In this way, the first mounting block and the first fastening bracket have an overlapping area in a thickness direction of the first fastening bracket, so that arrangement between the first fastening bracket and the first support plate is more compact. This helps improve space utilization of the folding mechanism.

In a possible implementation, the first fastening bracket is provided with a first mounting hole, and the first mounting hole penetrates a top surface and a bottom surface of the first fastening bracket; and the first guide block protrudes from a hole wall of the first mounting hole, and the first elastic member abuts against the hole wall of the first mounting hole.

It may be understood that, the first fastening bracket is provided with the first mounting hole, and the first guide block protrudes from the hole wall of the first mounting hole, so that a distance between the first guide block and the first support plate is reduced, and the first guide block is more readily disposed opposite to the first mounting block.

In a possible implementation, the first support plate includes a first support plate body and a first connection plate, the first support plate body includes a first fastening surface, and the first fastening surface and the second support surface are disposed back to back; and the first connection plate protrudes from the first fastening surface, the first mounting block protrudes from the first connection plate, and the first elastic member abuts against the first connection plate.

It may be understood that, the first connection plate is disposed, and the first mounting block protrudes from the first connection surface of the first connection plate, so that a distance between the first mounting block and the first fastening surface is increased, and the first mounting block can be more readily disposed opposite to the first guide block.

In a possible implementation, the first mounting block is at least partially located in the first mounting hole.

It may be understood that, the first mounting block is at least partially disposed in the first mounting hole, so that the first mounting block and the first fastening bracket have the overlapping area in the thickness direction of the first fastening bracket. This helps improve space utilization.

In a possible implementation, the first support plate further includes a first baffle plate and a second baffle plate, the first baffle plate and the second baffle plate both protrude from the first fastening surface, and the first baffle plate and the second baffle plate are further connected to two ends of the first connection plate, and are located on a same side of the first connection plate; and the first mounting block is located between the first baffle plate and the second baffle plate.

It may be understood that the first connection plate, the first baffle plate, and the second baffle plate can be configured to: protect the first elastic member and prevent the first elastic member from interference with another mechanical part.

In a possible implementation, when the folding mechanism is in an unfolded state, the first point of application of force is close to the second support surface relative to the second point of application of force. In other words, when the folding mechanism is in an unfolded state, an included angle formed between the second support surface and a connection line between the first point of application of force and the second point of application of force is an acute angle, that is, the first elastic member is disposed obliquely relative to the second support surface.

It may be understood that because the first elastic member is in a compressed state, the first elastic member may apply a fourth acting force to the first support plate. Because the first point of application of force is disposed close to the second support surface relative to the second point of application of force, the fourth acting force may generate a fourth component force in a positive direction of a Z-axis. In addition, because the first point of application of force is located on the side that is of the first rotation axis and that is away from the main shaft, the fourth component force may make the end part that is of the first support plate and that is close to the main shaft generate an acting force in a negative direction of the Z-axis. The end part that is of the first support plate and that is close to the main shaft has a trend of moving in the negative direction of the Z-axis, to ensure that the end part that is of the first support plate and that is close to the main shaft may not rise in the positive direction of the Z-axis, and further ensure that the end part that is of the first support plate and that is close to the main shaft may not cause damage or failure to the flexible display due to abutting against the flexible display.

In a possible implementation, the folding mechanism further includes a first attraction member and a second attraction member, the first attraction member is fastened to the first fastening bracket, the second attraction member is fastened to the first support plate, and the second attraction member is located on a side that is of the first rotation axis and that is close to the main shaft; and when the folding mechanism is in a folded state, the second attraction member and the first attraction member attract each other.

It may be understood that an attraction force generated between the first attraction member and the second attraction member may act on the first support plate. When the folding mechanism is in a folded state, the attraction force between the first attraction member and the second attraction member may apply a third acting force to the first support plate. The third acting force may form a third component force in a positive direction of an X-axis on the end part that is of the first support plate and that is close to the main shaft. Because the second attraction member is located on the side that is of the first rotation axis line and that is close to the main shaft, the third component force may cause the end part that is of the first support plate and that is close to the main shaft to expand in the direction away from the second support plate. In this case, the third component force may be as follows: The screen accommodating space enclosed by the first support plate, the main shaft, and the second support plate can be greatly increased.

It may be understood that the first attraction member is disposed on the first fastening bracket, the second attraction member is disposed on the first support plate, and the attraction force between the first attraction member and the second attraction member is used to cause the end part that is of the first support plate and that is close to the main shaft to expand, to greatly increase the size of the screen accommodating space.

In a possible implementation, relative to a first side surface of the first support plate, the first rotation axis is disposed close to a second side surface of the first support plate; and relative to the second side surface of the first support plate, the second attraction member is disposed close to the first side surface of the first support plate, where the first side surface and the second side surface of the first support plate are disposed back to back, and the first side surface of the first support plate faces the main shaft. In this way, the second attraction member can be disposed far away from the first rotation axis to a large extent. In this case, a torque applied by the second attraction member to the first support plate is large.

In a possible implementation, when the folding mechanism is in a folded state, a distance between the second attraction member and the first attraction member is a first distance, and when the folding mechanism is in an unfolded state, the distance between the second attraction member and the first attraction member is a second distance, where the second distance is greater than the first distance. In this way, when the folding mechanism is in an unfolded state, the attraction force between the second attraction member and the first attraction member is small. The attraction force between the second attraction member and the first attraction member is not likely to drive the first support plate to rotate relative to the first fastening bracket.

In a possible implementation, the first fastening bracket is provided with a first accommodation groove, and the first attraction member is at least partially located in the first accommodation groove; and/or the first support plate is provided with a first accommodation groove, and the second attraction member is at least partially located in the first accommodation groove.

It may be understood that the second attraction member and the first support plate have an overlapping area, so that the second attraction member and the first support plate are arranged more compactly, and space utilization is higher.

In a possible implementation, both the first attraction member and the second attraction member are magnets. It may be understood that material costs of the first attraction member and the second attraction member are low, and a structure of the folding mechanism is simple.

In a possible implementation, the folding mechanism further includes a third attraction member and a fourth attraction member, the third attraction member is fastened to the second fastening bracket, the fourth attraction member is fastened to the second support plate, and the third attraction member is located on a side that is of the second rotation axis and that is close to the main shaft; and when the folding mechanism is in a folded state, the third attraction member and the fourth attraction member attract each other.

It may be understood that an attraction force between the third attraction member and the fourth attraction member may be used to cause the end that is of the second support plate and that is close to the main shaft to expand in the direction away from the first support plate, and the screen accommodating space enclosed by the first support plate, the main shaft, and the second support plate may be greatly increased.

In a possible implementation, the first movable member includes a first rotation end and a second rotation end, the first rotation end of the first movable member is rotatably connected to the main shaft, and the second rotation end of the first movable member is rotatably connected to the first fastening bracket.

In a possible implementation, the first rotation end of the first movable member may be connected to the main shaft through a virtual shaft, a rotatable connection structure is simple, and a small space is occupied. This helps reduce a thickness of the folding mechanism, so that the folding mechanism and the electronic device are more likely to be light and thin.

In a possible implementation, the first movable member includes a connecting section, the connecting section of the first movable member connects the first rotation end and the second rotation end of the first movable member; and the first support plate is movably connected to the connecting section of the first movable member via a first revolute pair.

In a possible implementation, the first movable member is provided with a rotating shaft hole, and the first support plate is provided with a rotating shaft hole; and the first revolute pair includes a connecting bracket, a first pin shaft, and a second pin shaft, the connecting bracket is provided with a first pin shaft hole and a second pin shaft hole that are spaced from each other, the first pin shaft passes through the first pin shaft hole of the connecting bracket and two ends are connected to and are in the rotating shaft hole of the first movable member, the second pin shaft passes through the second pin shaft hole of the connecting bracket and two ends are connected to and are in the rotating shaft hole of the first support plate, and the connecting bracket rotatably connects the first pin shaft and the second pin shaft.

In a possible implementation, when the folding mechanism is in an unfolded state, the first support surface of the main shaft protrudes relative to the second support surface of the first support plate and the third support surface of the second support plate.

It may be understood that when the folding mechanism is used in the electronic device having the flexible display, and the electronic device is in an unfolded state, the second display area of the flexible display is recessed toward the main shaft to form an obvious crease, causing a light and shadow problem. However, in this implementation, the first support surface of the main shaft protrudes relative to the second support surface of the first support plate and the third support surface of the second support plate, so that the first support surface of the main shaft is closer to the second display area of the flexible display. In this way, when a retraction force of the flexible display and gravity of the flexible display drive the first support plate and the second support plate to fall toward the main shaft, the first support surface of the main shaft can support the second display area of the flexible display, to avoid a problem that the second display area of the flexible display forms a crease due to being recessed toward the main shaft, so as to avoid the light and shadow problem of the second display area of the flexible display.

According to a second aspect, this application provides an electronic device. The electronic device includes a first housing, a second housing, a flexible display, and the folding mechanism according to the first aspect, where the first fastening bracket is fastened to the first housing, and the second fastening bracket is fastened to the second housing; the flexible display includes a first display area, a second display area, and a third display area that are sequentially connected, the first display area is fastened to the first housing, and the third display area is fastened to the second housing; when the folding mechanism is in an unfolded state, the support surface supports the second display area; and when the folding mechanism is in a folded state, the second display area is located in the screen accommodating space.

It may be understood that when a second display area of the flexible display is located in the screen accommodating space, a free deformation space of the second display area of the flexible display is better released, and a bending degree of the second display area of the flexible display may be small. In this case, the second display area of the flexible display is not prone to damage, and reliability of the flexible display is good. Particularly, when the electronic device is in an unconventional environment like suffering a fall or an impact, the folding mechanism is not prone to squeeze the flexible display, and the flexible display is not prone to failure or the like. In addition, when the end part that is of the second support plate and that is close to the main shaft expands in the direction away from the first support plate, the second support plate may also drive some parts of the folding mechanism to move slightly, to reduce a gap between parts. In addition, the folding mechanism is more compact, and space utilization is higher.

It may be understood that the first elastic member is disposed, to greatly increase the size of the screen accommodating space. In this way, the problem that the screen accommodating space is reduced due to a retraction force of the flexible display driving the first support plate and the second support plate to rotate relative to the main shaft after the electronic device is folded many times can be resolved, and in addition, the problem that the screen accommodating space is reduced due to the retraction force of the flexible display and gravity of the flexible display driving the first support plate and the second support plate to fall toward the main shaft after the electronic device is folded many times can be resolved.

According to a third aspect, this application provides a folding mechanism. The folding mechanism includes a main shaft, a first fastening bracket, a second fastening bracket, a first movable member, a second movable member, a first support plate, a second support plate, and a first force-applying member, where the main shaft is located between the first fastening bracket and the second fastening bracket. The first movable member movably connects the main shaft and the first fastening bracket, and the second movable member movably connects the main shaft and the second fastening bracket. The first support plate movably connects the first fastening bracket and the first movable member, the second support plate movably connects the second fastening bracket and the second movable member, when the folding mechanism is in an unfolded state, the main shaft, the first support plate, and the second support plate jointly form a support surface, and when the folding mechanism is in a folded state, the first support plate and the second support plate are disposed opposite to each other, and enclose a screen accommodating space with the main shaft. A part of the first force-applying member is connected to the first support plate, a part is connected to the first fastening bracket, the first force-applying member is used to form a force in a second direction on an end part that is of the first support plate and that is close to the main shaft, and a first direction is a direction in which the second support plate points to the first support plate.

It may be understood that when the folding mechanism is in a folded state, because the first force-applying member is configured to form a force in the second direction on the end part that is of the first support plate and that is close to the main shaft, the end part that is of the first support plate and that is close to the main shaft may expand in a direction away from the second support plate. In this way, the screen accommodating space enclosed by the first support plate, the main shaft, and the second support plate can be greatly increased. When the folding mechanism is applied to an electronic device having a flexible display, and a second display area of the flexible display is located in the screen accommodating space, a free deformation space of the second display area of the flexible display is released, and a bending degree of the second display area of the flexible display may be small. In this case, the second display area of the flexible display is not prone to damage, and reliability of the flexible display is good. Particularly, when the electronic device is in an unconventional environment like suffering a fall or an impact, the folding mechanism is not prone to squeeze the flexible display, and the flexible display is not prone to failure or the like. In addition, when the end part that is of the first support plate and that is close to the main shaft expands in the direction away from the second support plate, the first support plate may also drive some parts of the folding mechanism to move slightly, to reduce a gap between some parts. In addition, the folding mechanism is more compact, and space utilization is higher.

In a possible implementation, the first force-applying member may be a first elastic member. The first force-applying member may alternatively be a first attraction member and a second attraction member.

In a possible implementation, the folding mechanism further includes a second force-applying member, a part of the second force-applying member is connected to the second support plate, a part of the second force-applying member is connected to the second fastening bracket, the second force-applying member is configured to form a force in the first direction on the end part that is of the second support plate and that is close to the main shaft, and the second direction is opposite to the first direction.

It may be understood that when the folding mechanism is in a folded state, because the second force-applying member is configured to form a force in the first direction on the end part that is of the second support plate and that is close to the main shaft, the end part that is of the second support plate and that is close to the main shaft may expand in a direction away from the first support plate. In this way, the screen accommodating space enclosed by the first support plate, the main shaft, and the second support plate can be greatly increased. When the folding mechanism is applied to an electronic device having a flexible display, and a second display area of the flexible display is located in the screen accommodating space, a free deformation space of the second display area of the flexible display is released, and a bending degree of the second display area of the flexible display may be small. In this case, the second display area of the flexible display is not prone to damage, and reliability of the flexible display is good. Particularly, when the electronic device is in an unconventional environment like suffering a fall or an impact, the folding mechanism is not prone to squeeze the flexible display, and the flexible display is not prone to failure or the like. In addition, when the end part that is of the first support plate and that is close to the main shaft expands in the direction away from the second support plate, the first support plate may also drive some parts of the folding mechanism to move slightly, to reduce a gap between some parts. In addition, the folding mechanism is more compact, and space utilization is higher.

In a possible implementation, the second force-applying member may be a second elastic member. The second force-applying member may alternatively be a third attraction member and a fourth attraction member.

According to a fourth aspect, this application provides an electronic device. The electronic device includes a first housing, a second housing, a flexible display, and the folding mechanism according to the third aspect, where the first fastening bracket is fastened to the first housing, and the second fastening bracket is fastened to the second housing; the flexible display includes a first display area, a second display area, and a third display area that are sequentially connected, the first display area is fastened to the first housing, and the third display area is fastened to the second housing; when the folding mechanism is in an unfolded state, the support surface supports the second display area; and when the folding mechanism is in a folded state, the second display area is located in the screen accommodating space.

It may be understood that when a second display area of the flexible display is located in the screen accommodating space, a free deformation space of the second display area of the flexible display is better released, and a bending degree of the second display area of the flexible display may be small. In this case, the second display area of the flexible display is not prone to damage, and reliability of the flexible display is good. Particularly, when the electronic device is in an unconventional environment like suffering a fall or an impact, the folding mechanism is not prone to squeeze the flexible display, and the flexible display is not prone to failure or the like. In addition, when the end part that is of the second support plate and that is close to the main shaft expands in the direction away from the first support plate, the second support plate may also drive some parts of the folding mechanism to move slightly, to reduce a gap between parts. In addition, the folding mechanism is more compact, and space utilization is higher.

It may be understood that the first elastic member is disposed, to greatly increase the size of the screen accommodating space. In this way, the problem that the screen accommodating space is reduced due to a retraction force of the flexible display driving the first support plate and the second support plate to rotate relative to the main shaft after the electronic device is folded many times can be resolved, and in addition, the problem that the screen accommodating space is reduced due to the retraction force of the flexible display and gravity of the flexible display driving the first support plate and the second support plate to fall toward the main shaft after the electronic device is folded many times can be resolved.

### BRIEF DESCRIPTION OF DRAWINGS

FIG. 1 is a diagram of a structure of an electronic device in an unfolded state provided in an implementation of this application;
FIG. 2 is a partial sectional view of an implementation of the electronic device shown in FIG. 1 at a line A-A;
FIG. 3 is a diagram of a structure of an implementation of the electronic device shown in FIG. 1 in a folded state;
FIG. 4 is a partial sectional view of an implementation of the electronic device shown in FIG. 3 at a line B-B;
FIG. 5 is a partial exploded view of an implementation of the electronic device shown in FIG. 1;
FIG. 6 is a partial exploded view of an implementation of a folding mechanism shown in FIG. 5;
FIG. 7 is a diagram of a structure of the folding mechanism shown in FIG. 6 from another angle;
FIG. 8 is a partial exploded view of an implementation of the folding mechanism shown in FIG. 7;
FIG. 9 is a diagram of a partial structure of an implementation of a main shaft shown in FIG. 7;
FIG. 10 is a partial sectional view of an implementation of the main shaft shown in FIG. 9 at a line C-C;
FIG. 11 is a partial exploded view of an implementation of an end part connecting component shown in FIG. 8;
FIG. 12 is a partial exploded view of the end part connecting component shown in FIG. 11 from another angle;
FIG. 13 is a partial sectional view of an implementation of a connecting component shown in FIG. 7 at a line D-D;
FIG. 14 is a partial sectional view of an implementation of the folding mechanism shown in FIG. 7 at a line E-E;
FIG. 15 is a diagram of structures of an implementation of a first support plate and a second support plate shown in FIG. 8;
FIG. 16 is a diagram of a partial structure of an implementation of the folding mechanism shown in FIG. 7;
FIG. 17 is a partial sectional view of an implementation of the folding mechanism shown in FIG. 16 at a line F-F from another angle;
FIG. 18 is a partial sectional view of an implementation of the folding mechanism shown in FIG. 16 at a line G-G;
FIG. 19 is a diagram of a partial structure of an implementation of the electronic device shown in FIG. 3;
FIG. 20 is a diagram of structures of a first fastening bracket and a second fastening bracket shown in FIG. 11 from another angle;
FIG. 21 is a diagram of structures of the first fastening bracket and the second fastening bracket shown in FIG. 20 from another angle;
FIG. 22 is an enlarged diagram of an implementation of the first support plate and the second support plate shown in FIG. 15;
FIG. 23 is a diagram of structures of the first support plate and the second support plate shown in FIG. 22 from another angle;
FIG. 24 is a diagram of a partial structure of the folding mechanism shown in FIG. 7 from another angle;
FIG. 25 is a partial sectional view of an implementation of the folding mechanism shown in FIG. 24 at a line H-H;
FIG. 26 is a partial sectional view of an implementation of a folding mechanism shown in FIG. 19 at a line I-I;
FIG. 27 is a partial sectional view of an implementation of a folding mechanism shown in FIG. 19 at a line J-J;
FIG. 28 is a diagram of a structure of the folding mechanism shown in FIG. 27 from another angle;
FIG. 29 is a partial sectional view of an implementation of the folding mechanism shown in FIG. 16 at a line K-K;
FIG. 30 is a diagram of a structure of an implementation of the folding mechanism shown in FIG. 29 in a folded state;
FIG. 31 is a diagram of a structure of the folding mechanism shown in FIG. 30 from another angle; and
FIG. 32 is a diagram of partial structures of another implementation of a folding mechanism and a flexible display provided in an implementation of this application.

### DESCRIPTION OF EMBODIMENTS

The following clearly and completely describes technical solutions in embodiments of this application with reference to the accompanying drawings in embodiments of this application.

In descriptions of this application, it should be noted that, unless otherwise specified and limited, terms "mounting", "connecting", and "connection" should be understood in a broad sense. For example, "connection" may be a detachable connection, or may be an undetachable connection; or may be a direct connection, or may be an indirect connection through an intermediate medium; or may be an electrical connection, or may be a mechanical connection. "Fastening" means that two parts are connected to each other and a relative location relationship remains unchanged after the two parts are connected to each other. "Rotatably connected" means that two parts are connected to each other and can rotate relative to each other after the two parts are connected to each other. "Slidably connected" means that two parts are connected to each other and can slide relative to each other after the two parts are connected to each other. "Movably connected" means that two parts are connected to each other and can move relative to each other after the two parts are connected to each other. In addition, obtaining an integrated structure of two parts by using an integral forming technique means that, in a process of forming one of the two parts, the part is connected to the other part, and the two parts do not need to be connected through reprocessing (for example, bonding, welding, clamping, or screwing). That a part A is disposed opposite to a part B may be that the part A is projected along a target direction to obtain projection C, the part B is projected along a target direction to obtain projection D, and the projection C and the projection D may at least largely overlap. In some embodiments, largely overlapping may be any one of the following cases: The projection C is completely located in the projection D; or the projection D is completely located in the projection C; or the projection C and the projection D cross each other, and a proportion of a crossing area of the projection C and the projection D to the projection C or the projection D is greater than 50%.

Orientation terms mentioned in embodiments of this application, for example, "top", "bottom", "inside", and "outside" are directions with reference to the accompanying drawings. Therefore, the orientation term is used to better and more clearly describe and understand embodiments of this application, instead of indicating or implying that a specified apparatus or element should have a specific orientation, and be constructed and operated in the specific orientation. Therefore, this cannot be understood as a limitation on embodiments of this application. A person of ordinary skill in the art may understand specific meanings of the foregoing terms based on specific cases.

In the specification and claims of this application, terms "first", "second", and the like are intended to distinguish between similar objects but do not indicate a specific order or sequence. It should be understood that the data termed in such a way is interchangeable in proper circumstances, so that embodiments of this application can be implemented in an order other than the order illustrated or described herein. In addition, the objects distinguished by "first", "second", and the like are usually of one type, and a quantity of objects is not limited, for example, there may be one or more first objects. In addition, in the specification and claims, "and/or" indicates at least one of connected objects, and a character "/" usually indicates an "or" relationship between associated objects. "A plurality of" means at least two.

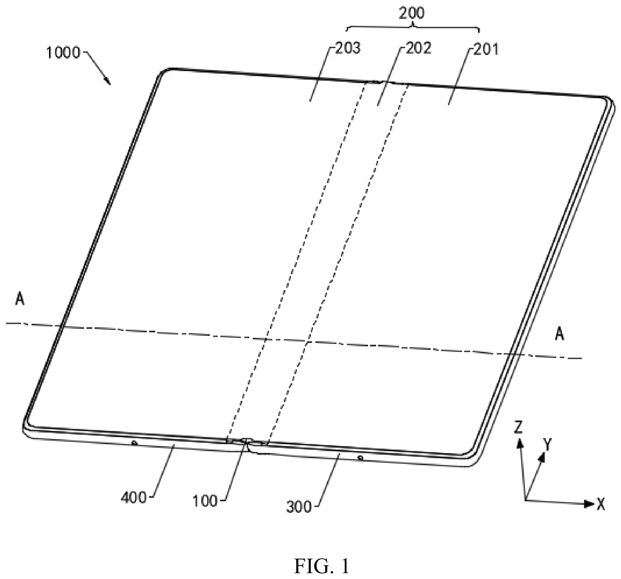

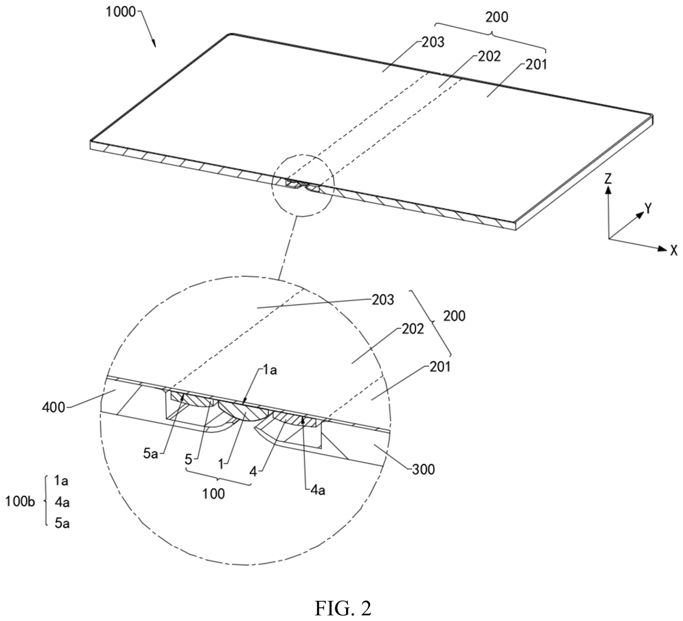

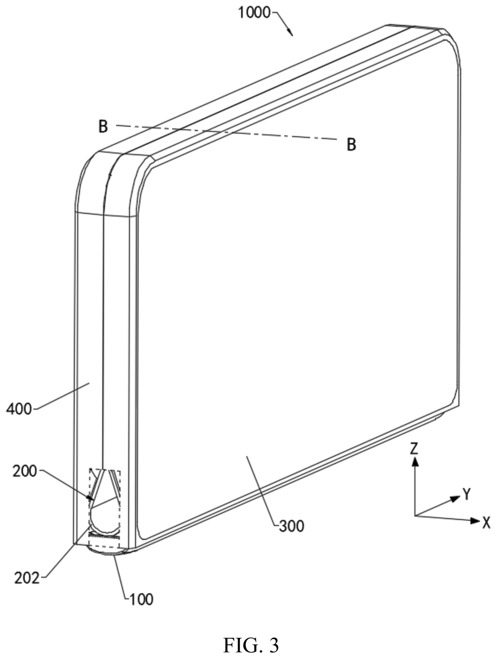

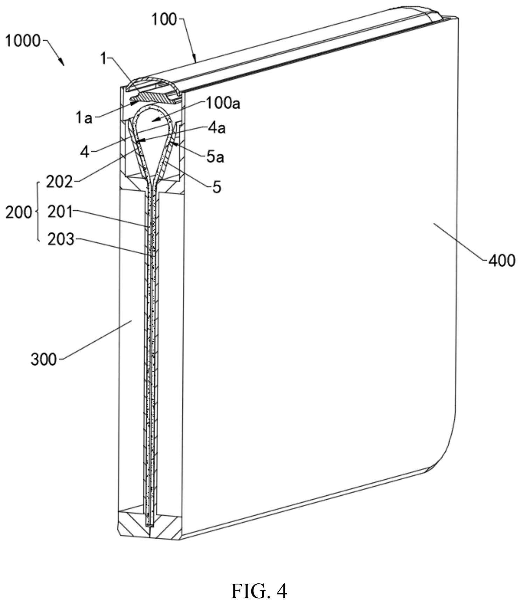

FIG. 1 is a diagram of a structure of an electronic device 1000 in an unfolded state provided in an implementation of this application. FIG. 2 is a partial sectional view of an implementation of the electronic device 1000 shown in FIG. 1 at a line A-A. FIG. 3 is a diagram of a structure of an implementation of the electronic device 1000 shown in FIG. 1 in a folded state. FIG. 4 is a partial sectional view of an implementation of the electronic device 1000 shown in FIG. 3 at a line B-B.

As shown in FIG. 1 to FIG. 4, this application provides the foldable electronic device 1000. The foldable electronic device 1000 may be a foldable device like a mobile phone, a tablet computer, a personal computer, a notebook computer, a vehicle-mounted device, or a wearable device (for example, a smart band). In embodiments of this application, an example in which the electronic device 1000 is a mobile phone is used for detailed description.

For ease of description, for example, a thickness direction of the electronic device 1000 is defined as a Z-axis direction, and an extension direction of a rotation axis of the electronic device 1000 is defined as a Y-axis direction, that is, a width direction of the electronic device 1000 is defined as the Y-axis direction. A direction perpendicular to the Y-axis direction and the Z-axis direction is an X-axis direction, that is, a length direction of the electronic device 1000 is an X-axis. It may be understood that a coordinate system of the electronic device 1000 may alternatively be flexibly set based on a specific requirement. For example, a negative direction of the X-axis is defined as a first direction, and a positive direction of the X-axis is defined as a second direction. In another implementation, the first direction and the second direction may alternatively be flexibly set based on a requirement, provided that the first direction is opposite to the second direction.

It may be understood that, in this implementation, a direction of a rotation axis of the electronic device 1000 is the Y-axis direction, that is, the electronic device 1000 may be unfolded or folded relatively in the Y-axis direction. In this way, when the electronic device 1000 is in a folded state, a dimension of the electronic device 1000 in the X-axis direction becomes smaller. This embodiment is described by using an example in which "the direction of the rotation axis of the electronic device 1000 is the Y-axis direction". In this case, the electronic device 1000 can be folded left and right, and folding and unfolding of the electronic device 1000 affect a length dimension of the electronic device 1000. In some other embodiments, the rotation axis of the electronic device 1000 may alternatively be in the X-axis direction, that is, the electronic device 1000 may be unfolded or folded relatively in the X-axis direction. In this case, the electronic device 1000 can be folded up and down, and folding and unfolding of the electronic device 1000 affect a width dimension of the electronic device 1000.

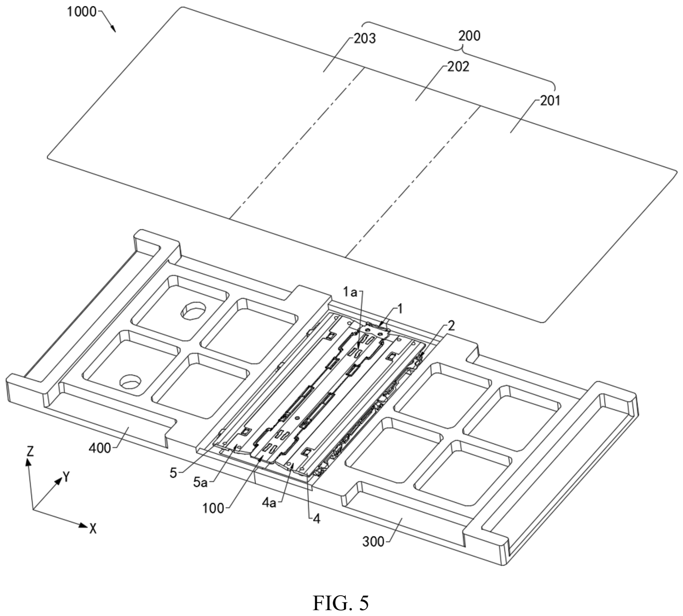

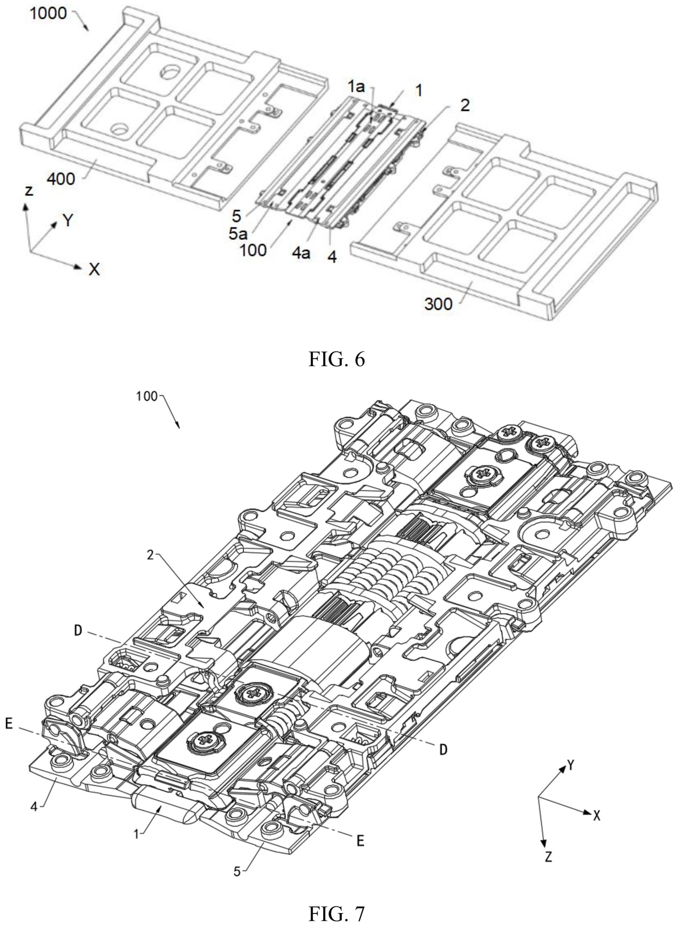

FIG. 5 is a partial exploded view of an implementation of the electronic device 1000 shown in FIG. 1. FIG. 6 is a partial exploded view of an implementation of a folding mechanism 100 shown in FIG. 5.

As shown in FIG. 5 and FIG. 6, the electronic device 1000 includes the folding mechanism 100, a flexible display 200, a first housing 300, and a second housing 400. The flexible display 200 may be an organic light-emitting diode (organic light-emitting diode, OLED) display, an active-matrix organic light-emitting diode (active-matrix organic light-emitting diode, AMOLED) display, a mini organic light-emitting diode (mini organic light-emitting diode) display, a micro organic light-emitting diode (micro light-emitting diode) display, a quantum dot light-emitting diode (quantum dot light-emitting diode, QLED) display, or the like. In addition, the folding mechanism 100 may be an inward folding mechanism, or may be an outward folding mechanism. The inward folding mechanism may be a folding mechanism that folds at least a part of the flexible display 200 between the first housing 300 and the second housing 400. The outward folding mechanism may be a folding mechanism that folds at least a part of the flexible display 200 to the outside of the first housing 300 and the second housing 400. A specific structure of the folding mechanism 100 is not limited in this application. In this implementation, an example in which the folding mechanism 100 is an inward folding mechanism is used for description. For example, a thickness direction of the folding mechanism 100 may be the Z-axis direction, and a length direction of the folding mechanism 100 may be the Y-axis direction. A width direction of the folding mechanism 100 may be the X-axis direction.

As shown in FIG. 5 and FIG. 6, for example, the folding mechanism 100 is connected between the first housing 300 and the second housing 400. The folding mechanism 100 is configured to unfold or fold the first housing 300 and the second housing 400 relative to each other. It may be understood that a direction in which the first housing 300 points to the second housing 400 may be the negative direction of the X-axis. A direction in which the second housing 400 points to the first housing 300 may be the positive direction of the X-axis.

As shown in FIG. 1 and FIG. 2, when the first housing 300 and the second housing 400 are unfolded relative to each other to an unfolded state, the electronic device 1000 is in an unfolded state, and the first housing 300 and the second housing 400 may be at 180°. In another embodiment, the first housing 300 and the second housing 400 may deviate slightly from the 180° alignment, for example, by angles such as 165°, 177°, or 185°.

As shown in FIG. 3 and FIG. 4, when the first housing 300 and the second housing 400 are folded relative to each other to a closed state, the electronic device 1000 is in a folded state, the first housing 300 and the second housing 400 may be closed to each other, and there may be no large gap between the first housing 300 and the second housing 400. In this way, the electronic device 1000 has good appearance experience, and has good waterproof, dustproof, and foreign object prevention performance. A case in which the first housing 300 and the second housing 400 are closed includes a case in which the first housing 300 and the second housing 400 abut against each other, or may include a case in which there is a small gap between the first housing 300 and the second housing 400. When there is a small gap between the first housing 300 and the second housing 400, some foreign objects outside the electronic device 1000 may not enter the gap between the first housing 300 and the second housing 400.

The first housing 300 and the second housing 400 may alternatively be unfolded or folded relative to each other to an intermediate state, so that the electronic device 1000 is in an intermediate state. An intermediate state may be any state between an unfolded state and a folded state.

Refer to FIG. 5. With reference to FIG. 1 to FIG. 4, the flexible display 200 includes a first display area 201, a second display area 202, and a third display area 203. The second display area 202 is connected between the first display area 201 and the third display area 203. In FIG. 1, FIG. 2, and FIG. 5, the first display area 201, the second display area 202, and the third display area 203 are schematically distinguished by using dashed lines. The first display area 201 of the flexible display 200 is fastened to the first housing 300. The third display area 203 is fastened to the second housing 400. In a process in which the first housing 300 and the second housing 400 are unfolded or folded relative to each other, the first housing 300 may drive the first display area 201 to move, the second housing 400 may drive the third display area 203 to move, the first display area 201 and the third display area 203 are unfolded or folded relative to each other, and the second display area 202 can be deformed.

It may be understood that, because the first display area 201 is fastened to the first housing 300, and the third display area 203 is fastened to the second housing 400, when the first housing 300 and the second housing 400 are unfolded or folded relative to each other, actions of relative unfolding and folding between the first display area 201 and the third display area 203 can be accurately controlled, so that a folding process and a movement form of the flexible display 200 are controllable, and reliability is high.

As shown in FIG. 1 and FIG. 2, when the electronic device 1000 is in an unfolded state, the flexible display 200 may be in an unfolded state. For example, the first display area 201, the second display area 202, and the third display area 203 of the flexible display 200 may be at 180°. In another embodiment, the first display area 201, the second display area 202, and the third display area 203 may deviate slightly from the 180° alignment, for example, by angles such as 165°, 177°, or 185°. In this case, the flexible display 200 has a continuous large-size display area, that is, the flexible display 200 can implement large-screen display, and therefore, user experience is good.

For example, when the electronic device 1000 is in an unfolded state, at least a part of the folding mechanism 100 may be configured to support the second display area 202. In this way, when the second display area 202 is subject to pressing force, squeezing force, impact force, or the like, the folding mechanism 100 may be configured to improve a pressure resistance capability and an impact resistance capability of the second display area 202, that is, ensure that the second display area 202 is not prone to be dented or the like.

As shown in FIG. 3 and FIG. 4, when the electronic device 1000 is in a folded state, the flexible display 200 is in a folded state. For example, the first display area 201 and the third display area 203 of the flexible display 200 approach each other. The second display area 202 is in a bent shape. In this case, the flexible display 200 may be approximately in a "water drop" shape. In addition, the flexible display 200 is located in a space enclosed by the first housing 300, the folding mechanism 100, and the second housing 400. The first display area 201 and the third display area 203 are located between the first housing 300 and the second housing 400. In this case, a planar dimension of the electronic device 1000 is small (with a small width dimension), which is convenient for a user to carry and store the electronic device 1000.

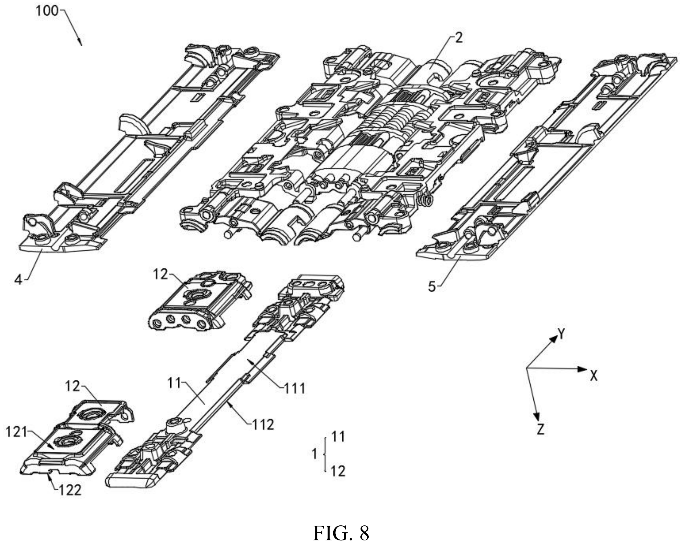

FIG. 7 is a diagram of a structure of the folding mechanism 100 shown in FIG. 6 from another angle. FIG. 8 is a partial exploded view of an implementation of the folding mechanism 100 shown in FIG. 7.

Refer to FIG. 7 and FIG. 8. With reference to FIG. 5 and FIG. 6, the folding mechanism 100 includes a main shaft 1, a connecting component 2, a first support plate 4, and a second support plate 5. A length extension direction of the main shaft 1 may be the Y-axis direction.

For example, the main shaft 1 is located between the first housing 300 and the second housing 400. The connecting component 2 connects the first housing 300, the main shaft 1, and the second housing 400. For example, there may be a plurality of connecting components 2, and the plurality of connecting components 2 are spaced from each other in the length extension direction of the main shaft 1, for example, may be connected to the top and the bottom of the main shaft 1. It may be understood that the connecting component 2 may be mainly configured to unfold or fold the first housing 300 and the second housing 400 relative to each other.

Refer to FIG. 7 and FIG. 8. With reference to FIG. 5 and FIG. 6, the first support plate 4 is located on a side that is of the main shaft 1 and that is close to the first housing 300. The first support plate 4 connects the main shaft 1 and the first housing 300 via the connecting component 2. A specific connection manner of the first support plate 4, the first housing 300, and the connecting component 2 is described below in detail with reference to related accompanying drawings. Details are not described herein again.

In addition, the second support plate 5 is located on a side that is of the main shaft 1 and that is close to the second housing 400. The second support plate 5 connects the second housing 400 and the main shaft 1 via the connecting component 2. It may be understood that the second support plate 5 and the first support plate 4 may be of a same or similar structure, a symmetrical or partially symmetrical structure, or different structures. In this implementation, the second support plate 5 and the first support plate 4 are of a symmetrical structure. For a basic design of a part structure of the second support plate 5, a design of a connection relationship between parts, and a design of a connection relationship between a part and another structure outside the component, refer to a related solution of the first support plate 4. In addition, the second support plate 5 and the first support plate 4 are allowed to be slightly different in detailed part structures or location arrangement of parts. Details are not described herein again. It may be understood that a direction in which the first support plate 4 points to the second support plate 5 may be the negative direction of the X-axis. A direction in which the second support plate 5 points to the first support plate 4 may be the positive direction of the X-axis.

As shown in FIG. 5 and FIG. 6, for example, the main shaft 1 includes a first support surface 1a. The first support surface 1a may be a plane. The first support plate 4 has a second support surface 4a. The second support surface 4a may be a plane. The second support plate 5 has a third support surface 5a. The third support surface 5a may be a plane.

As shown in FIG. 2, when the first housing 300 and the second housing 400 are unfolded relative to each other to an unfolded state (that is, the electronic device 1000 is in an unfolded state), the main shaft 1 is located between the first support plate 4 and the second support plate 5, and the first support plate 4 and the second support plate 5 expand relative to the main shaft 1. The first support surface 1a of the main shaft 1, the second support surface 4a of the first support plate 4, and the third support surface 5a of the second support plate 5 may form a support surface 100b, and the support surface 100b supports the second display area 202 of the flexible display 200. In this way, when the second display area 202 is touched, the second display area 202 is not prone to damage, a dent or the like caused by touching by an external force, to significantly improve reliability of the flexible display 200.

For example, when the electronic device 1000 is in an unfolded state, the first support surface 1a of the main shaft 1, the second support surface 4a of the first support plate 4, and the third support surface 5a of the second support plate 5 may be aligned with each other. In this case, flatness of the flexible display 200 is good, and user experience is good.

For example, the second support surface 4a of the first support plate 4 and the third support surface 5a of the second support plate 5 may be fastened to the second display area 202 of the flexible display 200 in a fastening manner like bonding, or the second support surface 4a of the first support plate 4 and the third support surface 5a of the second support plate 5 may not be connected to the second display area 202 of the flexible display 200.

As shown in FIG. 4, when the electronic device 1000 is in a folded state, the main shaft 1 is located between the first support plate 4 and the second support plate 5, the first support plate 4 and the second support plate 5 are located on a same side of the main shaft 1, the first support plate 4 and the second support plate 5 approach each other, the second support surface 4a of the first support plate 4 and the third support surface 5a of the second support plate 5 are disposed opposite to each other, and the first support surface 1a of the main shaft 1, the second support surface 4a of the first support plate 4, and the third support surface 5a of the second support plate 5 may enclose at least a part of a screen accommodating space 100a. The second display area 202 of the flexible display 200 may be located in the screen accommodating space 100a.

For example, an end part that is of the first support plate 4 and that is away from the main shaft 1 and an end part that is of the second support plate 5 and that is away from the main shaft 1 are close to each other. In an implementation, the first support surface 1a of the main shaft 1, the second support surface 4a of the first support plate 4, and the third support surface 5a of the second support plate 5 may form a cross section in a triangle shape. The first support plate 4 and the second support plate 5 may jointly act on the second display area 202 of the flexible display 200, so that the first display area 201 and the third display area 203 of the flexible display 200 can be close to each other, and even can be attached to each other, to make the flexible display 200 in the "water drop" shape. In another embodiment, the shape of the cross section formed by the first support surface 1a of the main shaft 1, the second support surface 4a of the first support plate 4, and the third support surface 5a of the second support plate 5 may alternatively be another shape. This is not specifically limited in this application.

It may be understood that, regardless of whether the electronic device 1000 is in an unfolded state or a folded state, an arrangement manner of the main shaft 1, the first support plate 4, and the second support plate 5 may affect a shape of the second display area 202, an angle between the second display area 202 and the first display area 201, an angle between the second display area 202 and the third display area 203, and the like. The arrangement manner of the main shaft 1, the first support plate 4, and the second support plate 5 plays a key role in a form of the flexible display 200 in an unfolded state or a folded state of the electronic device 1000. In this application, the arrangement manner of the main shaft 1, the first support plate 4, and the second support plate 5 is adjusted by setting structures of some parts (including the main shaft 1, the first support plate 4, the second support plate 5, and the like) of the folding mechanism 100 and through fitting between the parts. In this way, the form of the flexible display 200 is better controlled, and an appearance of the flexible display 200 better meets a user requirement, that is, the electronic device 1000 is highly delicate, and user experience of the electronic device 1000 is good. The arrangement manner of the main shaft 1, the first support plate 4, and the second support plate 5 may be an angle between the first support plate 4 and the main shaft 1, an angle between the second support plate 5 and the main shaft 1, an angle between the first support plate 4 and the second support plate 5, or the like.

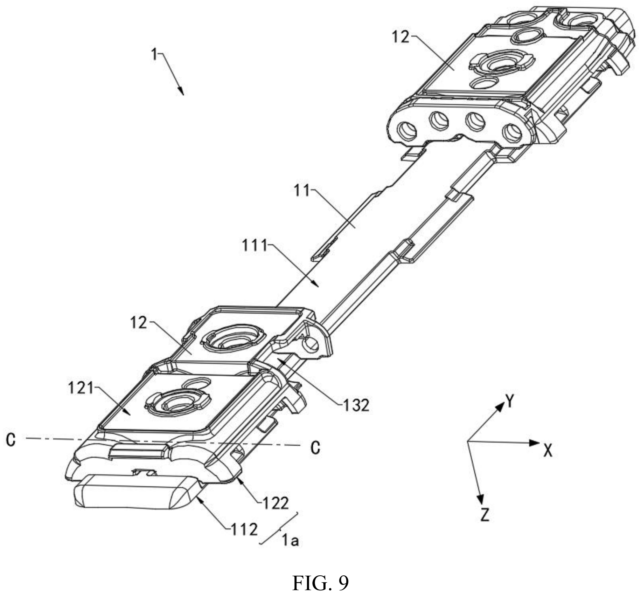

FIG. 9 is a diagram of a partial structure of an implementation of a main shaft 1 shown in FIG. 7.

As shown in FIG. 8 and FIG. 9, in some embodiments, the main shaft 1 includes a base 11 and an upper cover 12. For example, there may be two upper covers 12. In another implementation, a quantity of upper covers 12 is not specifically limited.

For example, the base 11 includes a top surface 111 and a bottom surface 112. The bottom surface 112 of the base 11 is connected to the top surface 111 of the base 11. The bottom surface 112 of the base 11 is a surface that is of the base 11 and that faces the flexible display 200. The top surface 111 of the base 11 is a surface that is of the base 11 and that faces away from the flexible display 200.

For example, the upper cover 12 includes a top surface 121 and a bottom surface 122. The bottom surface 122 of the upper cover 12 is connected to the top surface 121 of the upper cover 12.

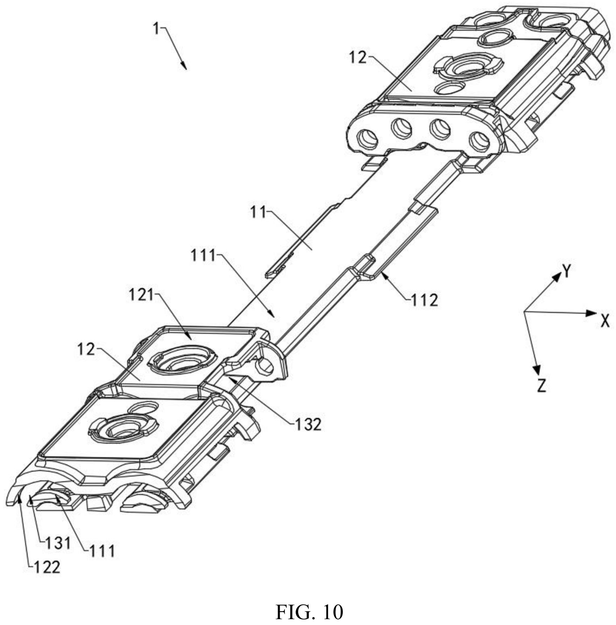

FIG. 10 is a partial sectional view of an implementation of the main shaft 1 shown in FIG. 9 at a line C-C.

As shown in FIG. 9 and FIG. 10, the upper cover 12 is fastened to the base 11. In an implementation, the base 11 is fastened to the upper cover 12 via a fastener (not shown in the figure). The fastener may be a screw, a screw bolt, a rivet, a pin, or the like.

As shown in FIG. 9, the bottom surface 122 of the upper cover 12 faces the top surface 111 of the base 11. A part of the bottom surface 122 of the upper cover 12 and the bottom surface 112 of the base 11 may be spliced into the first support surface 1a of the main shaft 1. In an implementation, the part of the bottom surface 122 of the upper cover 12 may be flush with the bottom surface 112 of the base 11.

As shown in FIG. 10, a part of the bottom surface 122 of the upper cover 12 and a part of the top surface 111 of the base 11 are disposed opposite to each other and spaced from each other, and form an arc-shaped groove 131.

As shown in FIG. 9 and FIG. 10, a plurality of three-dimensional space structures of the base 11 and a plurality of three-dimensional space structures of the upper cover 12 jointly form a plurality of movable spaces 132 of the main shaft 1. For example, the movable spaces 132 with different structures may be used to fit with mechanical parts with different structures, so that a connection structure between the main shaft 1 and the plurality of connecting components 2 is more flexible and diversified. The movable spaces 132 having a same structure may be used to cooperate with mechanical parts having a same structure. This helps reduce design difficulty and costs of the main shaft 1 and the connecting component 2. FIG. 9 and FIG. 10 schematically marks numbers of some movable spaces 132.

In some embodiments, some bumps (not shown in the figure) of the base 11 have a location limiting function. These bumps are located in the movable space 132, and are configured to limit the connecting component 2, to prevent the connecting component 2 from being accidentally detached from the main shaft 1, to improve connection reliability and movement reliability between the connecting component 2 and the main shaft 1, so as to improve reliability of the folding mechanism 100.

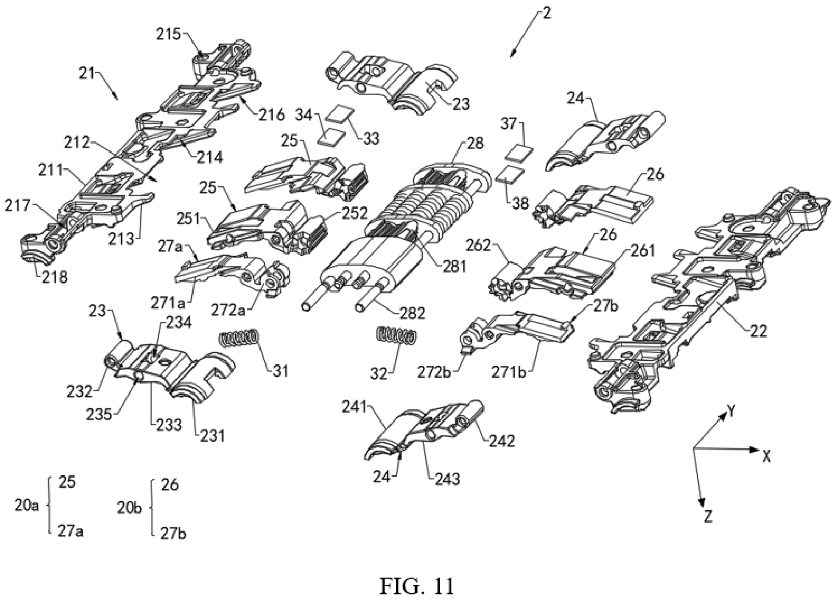

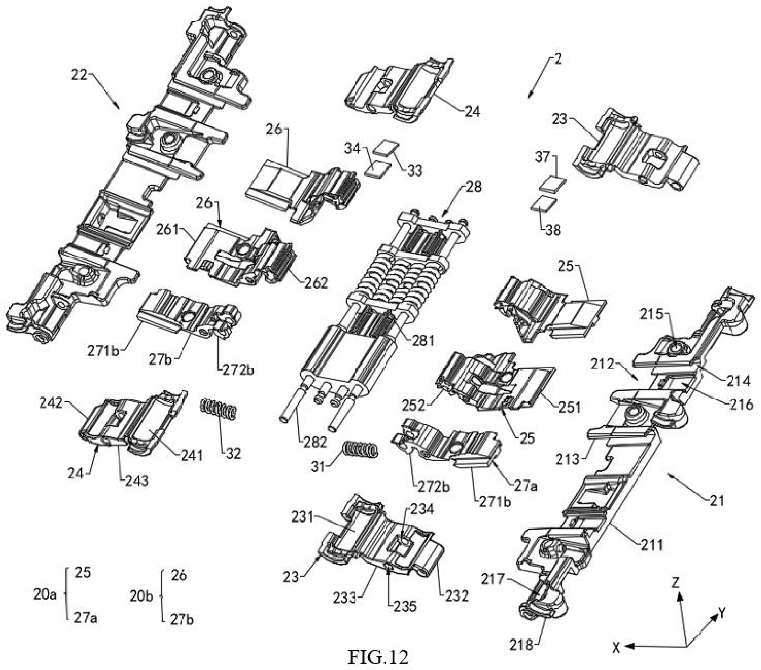

FIG. 11 is a partial exploded view of an implementation of a connecting component 2 shown in FIG. 8. FIG. 12 is a partial exploded view of the connecting component 2 shown in FIG. 11 from another angle.

As shown in FIG. 11 and FIG. 12, the connecting component 2 includes a first fastening bracket 21, a second fastening bracket 22, a first movable member 23, a second movable member 24, a first gear connecting rod 25, a second gear connecting rod 26, a first rotation member 27a, a second rotation member 27b, a damping member 28, a first elastic member 31, a second elastic member 32, a first attraction member 33, a second attraction member 34, a third attraction member 37, and a fourth attraction member 38. It may be understood that, although FIG. 11 and FIG. 12 show that quantities of the first movable member 23, the second movable member 24, the first gear connecting rod 25, and the second gear connecting rod 26 each are two, and quantities of the first rotation member 27a and the second rotation member 27b each are one, in another implementation, quantities of the first movable member 23, the second movable member 24, the first gear connecting rod 25, the second gear connecting rod 26, the first rotation member 27a, and the second rotation member 27b are not specifically limited. It may be understood that the first elastic member 31 may be used as a structure of a first force-applying member in this application. A combination of the first attraction member 33 and the second attraction member 34 may be used as another structure of the first force-applying member in this application. The second elastic member 32 may be used as a structure of a second force-applying member in this application. A combination of the third attraction member 37 and the fourth attraction member 38 may be used as another structure of the second force-applying member in this application.

It may be understood that both the first gear connecting rod 25 and the first rotation member 27a may be used as structures of a first connecting member 20a of the folding mechanism 100. In other words, the first connecting member 20a may include the first gear connecting rod 25 or the first rotation member 27a. Certainly, the first connecting member 20a may further include a first connecting member at another location of the folding mechanism 100. The first connecting member 20a movably connects the main shaft 1 and the first fastening bracket 21. A specific location of the first connecting member 20a is not limited in this application.

In addition, both the second gear connecting rod 26 and the second rotation member 27b may be used as structures of the second connecting member 20b of the connecting component 2. In other words, the second connecting member 20b may include the second gear connecting rod 26 or the second rotation member 27b. Certainly, the second connecting member 20b may further include a second connecting member 20b at another location of the folding mechanism 100. The second connecting member 20b movably connects the main shaft 1 and the second fastening bracket 22. A specific location of the second connecting member 20b is not limited in this application.

In some implementations, the connecting component 2 may include more or fewer structures. For example, the connecting component 2 may not include the first rotation member 27a, the second rotation member 27b, the damping member 28, or the like.

As shown in FIG. 11 and FIG. 12, the first fastening bracket 21 includes a first fastening bracket body 211, a plurality of through holes 212, a plurality of bumps 213, a plurality of grooves 214, and a plurality of fastening holes 215. The plurality of through holes 212, the plurality of bumps 213, and the plurality of grooves 214 are formed on the first fastening bracket body 211. The plurality of through holes 212, the plurality of bumps 213, and the plurality of grooves 214 are combined to each other, to form a plurality of sliding spaces 216 and a plurality of rotation spaces 217 that are spaced from each other. In addition, the plurality of fastening holes 215 are formed on the first fastening bracket body 211. FIG. 11 and FIG. 12 schematically mark numbers of some through holes 212, some bumps 213, some grooves 214, and some fastening holes 215.

The first fastening bracket 21 further includes an arc-shaped block 218. The arc-shaped block 218 may protrude from an end face of the first fastening bracket body 211.

It may be understood that the second fastening bracket 22 and the first fastening bracket 21 may be of a same structure, a symmetrical structure, a partially symmetrical structure, or different structures. This is not strictly limited in this application. For example, the second fastening bracket 22 and the first fastening bracket 21 may be of a symmetrical structure. For a basic design of a part structure of the second fastening bracket 22, a design of a connection relationship between parts, and a design of a connection relationship between a part and another structure outside the component, refer to a related solution of the first fastening bracket 21. In addition, the second fastening bracket 22 and the first fastening bracket 21 are allowed to be slightly different in detailed part structures or location arrangement of parts.

As shown in FIG. 11 and FIG. 12, the first gear connecting rod 25 includes a sliding end 251 and a rotation end 252. For example, the sliding end 251 of the first gear connecting rod 25 may be in a shape of a sliding block. The rotation end 252 of the first gear connecting rod 25 may have a gear structure.

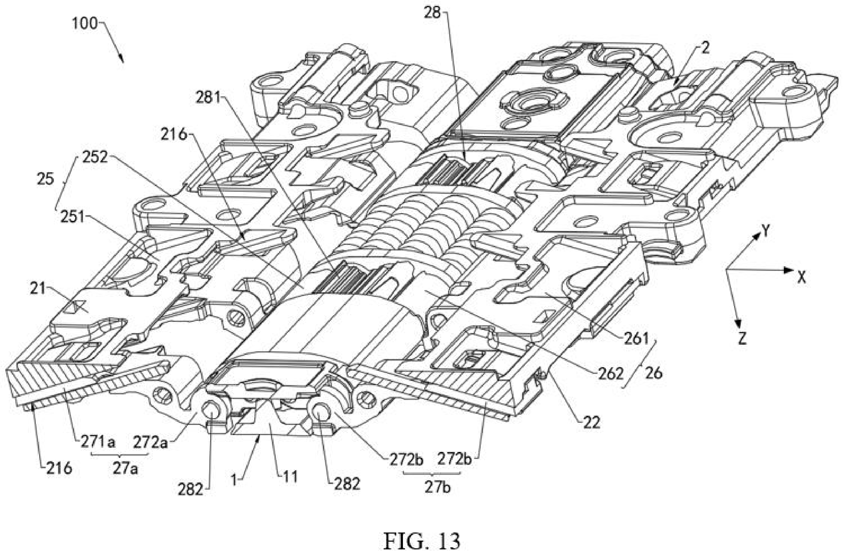

FIG. 13 is a partial sectional view of an implementation of a connecting component 2 shown in FIG. 7 at a line D-D.

Refer to FIG. 13. With reference to FIG. 11 and FIG. 12, the sliding end 251 of the first gear connecting rod 25 is slidably connected to the first fastening bracket 21. The rotation end 252 of the first gear connecting rod 25 is rotatably connected to the main shaft 1. In another implementation, a movable connection manner of the first gear connecting rod 25 and the first fastening bracket 21 and a movable connection manner of the first gear connecting rod 25 and the main shaft 1 are not specifically limited in this application.

For example, the sliding end 251 of the first gear connecting rod 25 is located in a sliding space 216 of the first fastening bracket 21 and may slide in the sliding space 216.

For example, the rotation end 252 of the first gear connecting rod 25 may be connected to the main shaft 1 via a solid shaft. This is not specifically limited in this application strictly.

Refer to FIG. 13. With reference to FIG. 11 and FIG. 12, the second gear connecting rod 26 includes a sliding end 261 and a rotation end 262. The sliding end 261 of the second gear connecting rod 26 is slidably connected to the second fastening bracket 22. The rotation end 262 of the second gear connecting rod 26 is rotatably connected to the main shaft 1. It may be understood that the second gear connecting rod 26 and the first gear connecting rod 25 may be of a same structure, a symmetrical structure, a partially symmetrical structure, or different structures. This is not strictly limited in this application. For example, the second gear connecting rod 26 and the first gear connecting rod 25 may be of a symmetrical structure. For a basic design of a part structure of the second gear connecting rod 26, a design of a connection relationship between parts, and a design of a connection relationship between a part and another structure outside the component, refer to a related solution of the first gear connecting rod 25. In addition, the second gear connecting rod 26 and the first gear connecting rod 25 are allowed to be slightly different in detailed part structures or location arrangement of parts.

Refer to FIG. 13. With reference to FIG. 11 and FIG. 12, the damping member 28 is fastened to the base 11 of the main shaft 1. It may be understood that the damping member 28 may apply a damping force to the first gear connecting rod 25 and the second gear connecting rod 26, to limit the first gear connecting rod 25 and the second gear connecting rod 26 to some extent. In other words, when the first gear connecting rod 25 and the second gear connecting rod 26 are not subjected to a large external force, the damping member 28 may make the first gear connecting rod 25 and the second gear connecting rod 26 remain in a preset relative location relationship. In other words, the folding mechanism 100 may stay at a preset angle, and the folding mechanism 100 may remain in an unfolded state or a folded state, to improve user experience of the folding mechanism 100 and the electronic device 1000.

For example, the damping member 28 includes a synchronization gear 281. The rotation end 252 of the first gear connecting rod 25 is engaged with the rotation end 262 of the second gear connecting rod 26 via a plurality of synchronization gears 281. It may be understood that the rotation end 252 of the first gear connecting rod 25 is connected to the rotation end 262 of the second gear connecting rod 26 via the plurality of synchronization gears 281, so that a rotation angle of the rotation end 252 of the first gear connecting rod 25 and a rotation angle of the rotation end 262 of the second gear connecting rod 26 have a same size and opposite directions, and rotation actions of the first gear connecting rod 25 and the second gear connecting rod 26 are kept synchronous relative to the main shaft 1, that is, the first gear connecting rod 25 and the second gear connecting rod 26 are synchronously close to or away from each other.

For example, the damping member 28 further includes a plurality of rotating shafts 282. The plurality of rotating shafts 282 are spaced from each other and fastened to the main shaft 1. The rotation end 252 of the first gear connecting rod 25 is rotatably connected to one of the rotating shafts 282. The rotation end 262 of the second gear connecting rod 26 is rotatably connected to another rotating shaft 282. In this way, the first gear connecting rod 25 and the second gear connecting rod 26 may be rotatably connected to the main shaft 1 via the rotating shafts 282 of the damping member 28.

It may be understood that although FIG. 11 to FIG. 13 show a structure of the damping member 28, a specific structure of the damping member 28 is not limited in this application.

Refer to FIG. 13. With reference to FIG. 11 and FIG. 12, the first rotation member 27a includes a sliding end 271a and a rotation end 272a connected to the sliding end 271a. The sliding end 271a of the first rotation member 27a is slidably connected to the first fastening bracket 21. The rotation end 272a of the first rotation member 27a is rotatably connected to the main shaft 1. In another implementation, a movable connection manner of the first rotation member 27a and the first fastening bracket 21 and a movable connection manner of the first rotation member 27a and the main shaft 1 are not specifically limited in this application.

For example, the sliding end 271a of the first rotation member 27a is located in a sliding space 216 of the first fastening bracket 21 and may slide in the sliding space 216.

For example, the rotation end 272a of the first rotation member 27a is rotatably connected to one of the rotating shafts 282. The first rotation member 27a may be rotatably connected to the main shaft 1 via the rotating shaft 282 of the damping member 28.

Refer to FIG. 13. With reference to FIG. 11 and FIG. 12, the second rotation member 27b includes a sliding end 271b and a rotation end 272b. The sliding end 271b of the second rotation member 27b is slidably connected to the second fastening bracket 22. The rotation end 272b of the second rotation member 27b is rotatably connected to the main shaft 1. It may be understood that the second rotation member 27b and the first rotation member 27a may be of a same structure, a symmetrical structure, a partially symmetrical structure, or different structures. This is not strictly limited in this application. For example, the second rotation member 27b and the first rotation member 27a may be of a symmetrical structure. For a basic design of a part structure of the second rotation member 27b, a design of a connection relationship between parts, and a design of a connection relationship between a part and another structure outside the component, refer to a related solution of the first rotation member 27a. In addition, the second rotation member 27b and the first rotation member 27a are allowed to be slightly different in detailed part structures or location arrangement of parts.

As shown in FIG. 13, the first fastening bracket 21 may be fastened to the first housing 300 (refer to FIG. 5 and FIG. 6). The second fastening bracket 22 is fastened to the second housing 400 (refer to FIG. 5 and FIG. 6). For example, the first fastening bracket 21 may be connected to the first housing 300 via screws. The second fastening bracket 22 may be connected to the second housing 400 via screws.

It may be understood that, the first fastening bracket 21 is fastened to the first housing 300, the second fastening bracket 22 is fastened to the second housing 400, the first gear connecting rod 25 connects the first fastening bracket 21 and the main shaft 1, the first rotation member 27a connects the first fastening bracket 21 and the main shaft 1, the second gear connecting rod 26 connects the second fastening bracket 22 and the main shaft 1, and the second rotation member 27b connects the second fastening bracket 22 and the main shaft 1, so that the first housing 300 and the second housing 400 may be connected via the first fastening bracket 21, the first gear connecting rod 25, the second gear connecting rod 26, the first rotation member 27a, the second rotation member 27b, and the second fastening bracket 22. In this way, when the electronic device 1000 switches from an unfolded state to a folded state, the first housing 300 and the second housing 400 approach each other, the first housing 300 can drive, via the first gear connecting rod 25 and the first rotation member 27a, the first fastening bracket 21 to rotate relative to the main shaft 1, and the second housing 400 can drive, via the second gear connecting rod 26 and the second rotation member 27b, the second fastening bracket 22 to rotate relative to the main shaft 1. When the electronic device 1000 switches from a folded state to an unfolded state, the first housing 300 and the second housing 400 are unfolded relative to each other, the first housing 300 can drive, via the first gear connecting rod 25 and the first rotation member 27a, the first fastening bracket 21 to rotate relative to the main shaft 1, and the second housing 400 can drive, via the second gear connecting rod 26 and the second rotation member 27b, the second fastening bracket 22 to rotate relative to the main shaft 1.

It may be understood that, the sliding end 251 of the first gear connecting rod 25 is slidably connected to the first fastening bracket 21, the rotation end 252 of the first gear connecting rod 25 is rotatably connected to the main shaft 1, the sliding end 261 of the second gear connecting rod 26 is slidably connected to the second fastening bracket 22, and the rotation end 262 of the second gear connecting rod 26 is rotatably connected to the main shaft 1, so that in a process in which the first housing 300 and the second housing 400 are unfolded or folded relative to each other, a relative motion track of the first fastening bracket 21 and the main shaft 1 can be determined, and a relative motion track of the second fastening bracket 22 and the main shaft 1 can be determined. Certainly, the first rotation member 27a and the first fastening bracket 21 are mutually cooperated and the second rotation member 27b and the second fastening bracket 22 are mutually cooperated, so that in the process in which the first housing 300 and the second housing 400 are unfolded or folded relative to each other, the relative motion track of the first fastening bracket 21 and the main shaft 1 can be determined, and the relative motion track of the second fastening bracket 22 and the main shaft 1 can be determined.

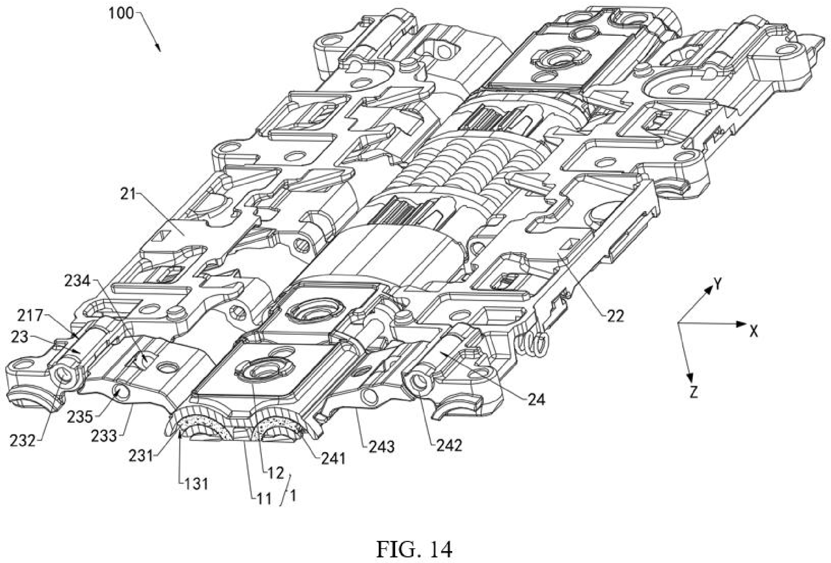

FIG. 14 is a partial sectional view of an implementation of the folding mechanism 100 shown in FIG. 7 at a line E-E.

Refer to FIG. 14. With reference to FIG. 11 and FIG. 12, the first movable member 23 includes a first rotation end 231, a second rotation end 232, and a connecting section 233 that are sequentially connected. The connecting section 233 of the first movable member 23 connects the first rotation end 231 and the second rotation end 232 of the first movable member 23.

For example, the first rotation end 231 of the first movable member 23 may be arc-shaped. The second rotation end 232 of the first movable member 23 may be cylindrical. In another implementation, the first rotation end 231 and the second rotation end 232 of the first movable member 23 may alternatively adopt other structures.

For example, the connecting section 233 of the first movable member 23 is provided with an avoidance hole 234 and a rotating shaft hole 235. The avoidance hole 234 of the first movable member 23 may penetrate the top surface and the bottom surface of the connecting section 233 of the first movable member 23. The rotating shaft hole 235 of the first movable member 23 penetrates two end surfaces of the connecting section 233 of the first movable member 23 and penetrates the avoidance hole 234 of the first movable member 23.

As shown in FIG. 14, the first rotation end 231 of the first movable member 23 is rotatably connected to the main shaft 1. The second rotation end 232 of the first movable member 23 is rotatably connected to the first fastening bracket 21. In another implementation, a movable connection manner of the first movable member 23 and the main shaft 1 and a movable connection manner of the first movable member 23 and the first fastening bracket 21 are not specifically limited in this application.

For example, the first rotation end 231 of the first movable member 23 may be located in the arc-shaped groove 131 of the main shaft 1. The first rotation end 231 of the first movable member 23 may rotate in the arc-shaped groove 131 of the main shaft 1. It may be understood that the first rotation end 231 of the first movable member 23 is connected to the main shaft 1 through a virtual shaft, a rotatable connection structure is simple, and a small space is occupied. This helps reduce a thickness of the folding mechanism 100, so that the folding mechanism 100 and the electronic device 1000 are more likely to be light and thin. In some other embodiments, the first rotation end 231 of the first movable member 23 may alternatively be connected to the main shaft 1 via a real shaft. This is not strictly limited in embodiments of this application.

For example, the second rotation end 232 of the first movable member 23 may be at least partially located in the rotation space 217 of the first fastening bracket 21. The second rotation end 232 of the first movable member 23 may rotate in the rotation space 217 of the first fastening bracket 21.

Refer to FIG. 14. With reference to FIG. 11 and FIG. 12, the second movable member 24 includes a first rotation end 241, a second rotation end 242, and a connecting section 243. The first rotation end 241 of the second movable member 24 is rotatably connected to the main shaft 1. The second rotation end 242 of the second movable member 24 is rotatably connected to the second fastening bracket 22. It may be understood that the second movable member 24 and the first movable member 23 may be of a same structure, a symmetrical structure, a partially symmetrical structure, or different structures. This is not strictly limited in this application. For example, the second movable member 24 and the first movable member 23 may be of a symmetrical structure. For a basic design of a part structure of the second movable member 24, a design of a connection relationship between parts, and a design of a connection relationship between a part and another structure outside the component, refer to a related solution of the first movable member 23. For example, the second movable member 24 and the first movable member 23 are also allowed to be slightly different in detailed part structures or location arrangement of parts.

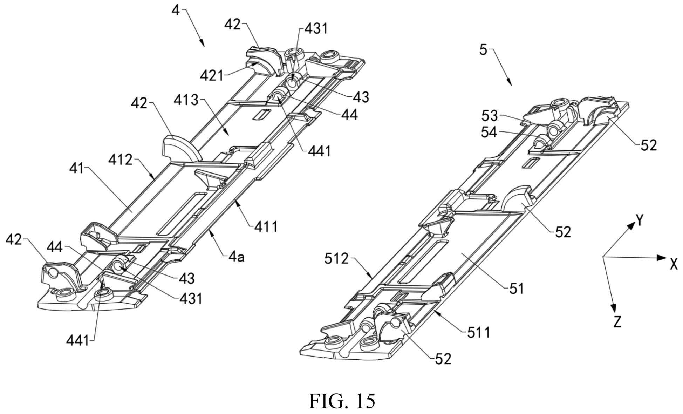

FIG. 15 is a diagram of structures of an implementation of a first support plate 4 and a second support plate 5 shown in FIG. 8.

As shown in FIG. 15, the first support plate 4 includes a first support plate body 41 and a first rotating block 42. It may be understood that a quantity of first rotating blocks 42 is not limited to three shown in FIG. 15. In another implementation, a quantity of first rotating blocks 42 is not specifically limited.

For example, the first support plate body 41 has a second support surface 4a and a first fastening surface 413 that are disposed back to back. In other words, the second support surface 4a of the first support plate 4 is located on the first support plate body 41. In addition, the first support plate body 41 further includes a right side surface 411 (also referred to as a first side surface 411) and a left side surface 412 (also referred to as a second side surface 412).

For example, the first rotating block 42 protrudes from the first fastening surface 413. The first rotating block 42 has an arc-shaped space 421.

For example, the first support plate 4 further includes a first pin shaft block 43 and a second pin shaft block 44 that are spaced from each other. The first pin shaft block 43 and the second pin shaft block 44 protrude from the first fastening surface 413. The first pin shaft block 43 is provided with a rotating shaft hole 431. The second pin shaft block 44 is provided with a rotating shaft hole 441. The rotating shaft hole 431 of the first pin shaft block 43 and the rotating shaft hole 441 of the second pin shaft block 44 are disposed opposite to each other.

It may be understood that the first rotating block 42, the first pin shaft block 43, and the second pin shaft block 44 of the first support plate 4 may jointly form a connection structure. The first support plate 4 may include a plurality of connection structures that are spaced from each other.

As shown in FIG. 15, the second support plate 5 includes a second support plate body 51, a second rotating block 52, a third rotating shaft block 53, and a fourth rotating shaft block 54. It may be understood that the second support plate 5 and the first support plate 4 may be of a same structure, a symmetrical structure, a partially symmetrical structure, or different structures. This is not strictly limited in this application. For example, the second support plate 5 and the first support plate 4 may be of a symmetrical structure. For a basic design of a part structure of the second support plate 5, a design of a connection relationship between parts, and a design of a connection relationship between a part and another structure outside the component, refer to a related solution of the first support plate 4. For example, the second support plate 5 and the first support plate 4 are also allowed to be slightly different in detailed part structures or location arrangement of parts.

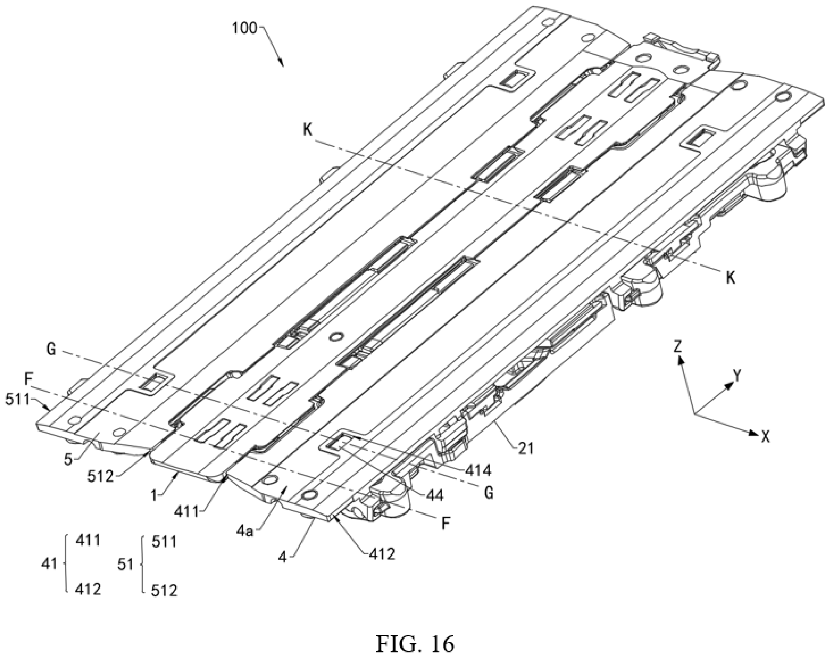

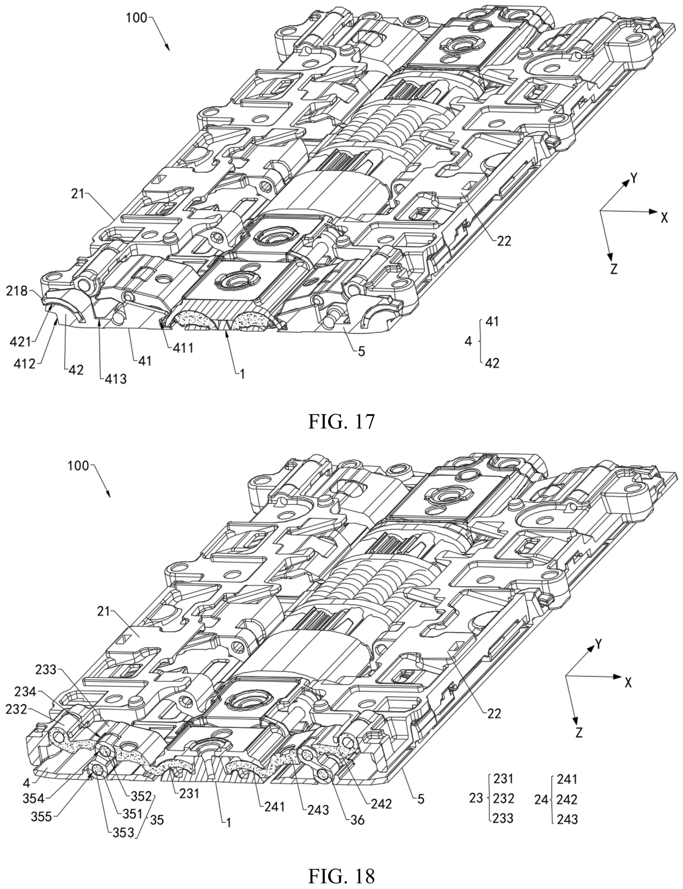

FIG. 16 is a diagram of a partial structure of an implementation of the folding mechanism 100 shown in FIG. 7. FIG. 17 is a partial sectional view of an implementation of the folding mechanism 100 shown in FIG. 16 at a line F-F from another angle.

Refer to FIG. 16 and FIG. 17. With reference to FIG. 15, the main shaft 1 is located between the first support plate 4 and the second support plate 5. The right side surface 411 of the first support plate body 41 is disposed facing the main shaft 1 relative to the left side surface 412 of the first support plate body 41. A left side surface 512 of the second support plate body 51 is disposed facing the main shaft 1 relative to a right side surface 511 of the second support plate body 51.

For example, the first support plate 4 is further rotatably connected to the first fastening bracket 21. For example, the arc-shaped block 218 of the first fastening bracket 21 may be located in the arc-shaped space 421 of the first rotating block 42 of the first support plate 4. The arc-shaped block 218 of the first fastening bracket 21 may rotate in the arc-shaped space 421. It may be understood that the first support plate 4 is connected to the first fastening bracket 21 through a virtual shaft, a rotatable connection structure is simple, and a small space is occupied. This helps reduce a thickness of the folding mechanism 100, so that the folding mechanism 100 and the electronic device 1000 are more likely to be light and thin. In some other embodiments, the first support plate 4 may alternatively be connected to the first fastening bracket 21 via a real shaft. This is not strictly limited in embodiments of this application. In another implementation, a connection manner of the first support plate 4 and the first fastening bracket 21 is not specifically limited.

For example, a part of the first fastening bracket 21 is located on a side close to the first fastening surface 413 of the first support plate body 41, and a part of the first fastening bracket 21 is located on a side close to the left side surface 412 of the first support plate body 41. In this case, the first fastening surface 413 of the first support plate body 41 faces the first fastening bracket 21.

It may be understood that for a connection manner of the second support plate 5 and the second fastening bracket 22, refer to the connection manner of the first support plate 4 and the first fastening bracket 21. Details are not described herein again.

FIG. 18 is a partial sectional view of an implementation of the folding mechanism 100 shown in FIG. 16 at a line G-G.

As shown in FIG. 18, for example, the first support plate 4 is movably connected to the connecting section 233 of the first movable member 23 via a first revolute pair 35. In this case, the first support plate 4 is connected to the main shaft 1 via the first movable member 23. In another implementation, a movable connection manner of the first support plate 4 and the first movable member 23 is not specifically limited.

As shown in FIG. 18, for example, the first revolute pair 35 includes a connecting bracket 351, a first pin shaft 352, and a second pin shaft 353. The connecting bracket 351 is provided with a first pin shaft hole 354 and a second pin shaft hole 355 that are spaced from each other. The first pin shaft 352 passes through the first pin shaft hole 354 of the connecting bracket 351. The second pin shaft 353 passes through the second pin shaft hole 355 of the connecting bracket 351. The connecting bracket 351 rotatably connects the first pin shaft 352 and the second pin shaft 353. In other words, the connecting bracket 351 may rotate relative to the first pin shaft 352 and the second pin shaft 353.

As shown in FIG. 18, a part of the connecting bracket 351 of the first revolute pair 35 is located in the avoidance hole 234 of the connecting section 233 of the first movable member 23. Two ends of the first pin shaft 352 of the first revolute pair 35 are connected to and are in the rotating shaft hole 235 of the connecting section 233 of the first movable member 23 (refer to FIG. 11 and FIG. 12).

Refer to FIG. 18. With reference to FIG. 15, a part of the connecting bracket 351 of the first revolute pair 35 is located in a space between the first pin shaft block 43 and the second pin shaft block 44 of the first support plate 4. Two ends of the second pin shaft 353 of the first revolute pair 35 are connected to and are in the rotating shaft hole 431 of the first pin shaft block 43 and the rotating shaft hole 441 of the second pin shaft block 44.

As shown in FIG. 18, for example, the second support plate 5 is connected to the second movable member 24 via a second revolute pair 36. In this case, the second support plate 5 is connected to the main shaft 1 via the second movable member 24. It may be understood that for a structure of the second revolute pair 36, refer to a structure of the first revolute pair 35. Details are not described herein again. In addition, for a connection manner of the second support plate 5 and the second revolute pair 36 and a connection manner of the second revolute pair 36 and the second movable member 24, refer to a connection manner of the first support plate 4 and the first revolute pair 35 and a connection manner of the first revolute pair 35 and the first movable member 23. Details are not described herein again.

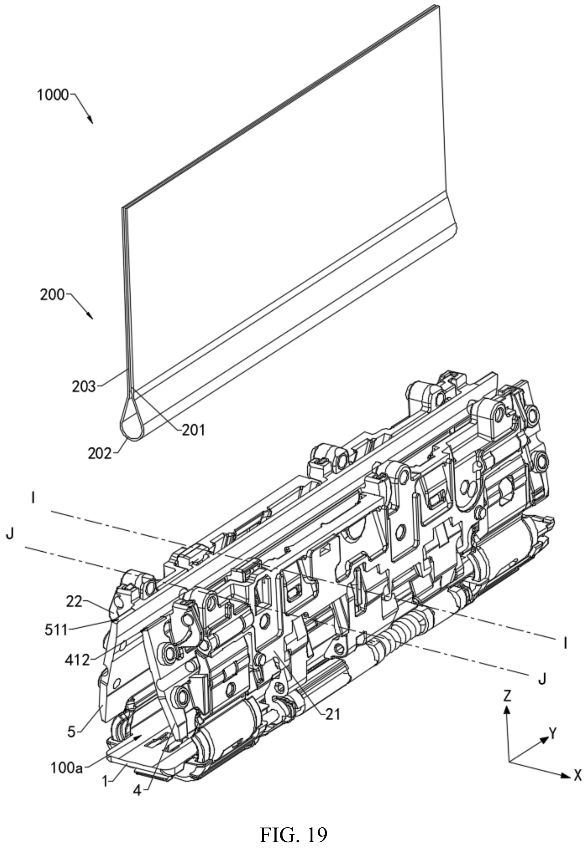

FIG. 19 is a diagram of a partial structure of an implementation of the electronic device 1000 shown in FIG. 3.

As shown in FIG. 19, when the folding mechanism 100 is in a folded state, the main shaft 1 is located between the first support plate 4 and the second support plate 5, the first support plate 4 and the second support plate 5 are located on a same side of the main shaft 1, the first support plate 4 and the second support plate 5 are disposed opposite to each other, the first fastening bracket 21 is at least partially located on a side that is of the first support plate 4 and that is away from the second support plate 5, and the second fastening bracket 22 is at least partially located on a side that is of the second support plate 5 and that is away from the first support plate 4. In other words, the first support plate 4 and the second support plate 5 may be located between the first fastening bracket 21 and the second fastening bracket 22.

For example, an end part that is of the first support plate 4 and that is close to the left side surface 412 of the first support plate 4 and an end part that is of the second support plate 5 and that is close to the right side surface 511 of the second support plate 5 approach each other. An end part that is of the first support plate 4 and that is close to the left side surface 412 of the first support plate 4 and an end part that is of the second support plate 5 and that is close to the right side surface 511 of the second support plate 5 are away from each other. In this case, the main shaft 1, the first support plate 4, and the second support plate 5 may roughly enclose the screen accommodating space 100a whose cross section is a triangle. The second display area 202 of the flexible display 200 may be located in the screen accommodating space 100a.

In an implementation, when the folding mechanism 100 is in a folded state, the first support plate 4 and the second support plate 5 may apply an acting force to the second display area 202, so that the second display area 202 is bent, and the first display area 201 and the third display area 203 approach each other. In this case, the flexible display 200 may be approximately in the "water drop" shape. In another implementation, the flexible display 200 may alternatively form another shape in a folded state. This is not specifically limited in this application.

It may be understood that the screen accommodating space 100a is configured to accommodate the second display area 202 of the flexible display 200. If the screen accommodating space 100a is small, a free deformation space of the second display area 202 of the flexible display 200 is small, and a bending degree of the second display area 202 of the flexible display 200 is large. In this case, the second display area 202 of the flexible display 200 is prone to damage. Particularly, when the electronic device 1000 is in an unconventional environment like suffering a fall or an impact, the folding mechanism 100 is prone to squeeze the flexible display 200, causing failure or the like of the flexible display 200. The following describes several setting manners of increasing the screen accommodating space 100a in detail with reference to related accompanying drawings. It may be understood that because the first support plate 4 is rotatably connected to the first fastening bracket 21 (for example, the first support plate 4 and the first fastening bracket 21 are constrained and limited by a virtual axis), the first support plate 4 is connected to the first movable member 23 via the first revolute pair 35, and a motion track of the first support plate 4 is restricted by the first fastening bracket 21 and the first movable member 23. The second support plate 5 is rotatably connected to the second fastening bracket 22 (for example, the second support plate 5 and the second fastening bracket 22 are constrained and limited by a virtual axis), the second support plate 5 is connected to the second movable member 24 via the second revolute pair 36, and a motion track of the second support plate 5 is restricted by the second fastening bracket 22 and the second movable member 24. When motion tracks of the first fastening bracket 21 and the second fastening bracket 22 relative to the main shaft 1 are determined, motion tracks of the first support plate 4 and the second support plate 5 may also be determined.

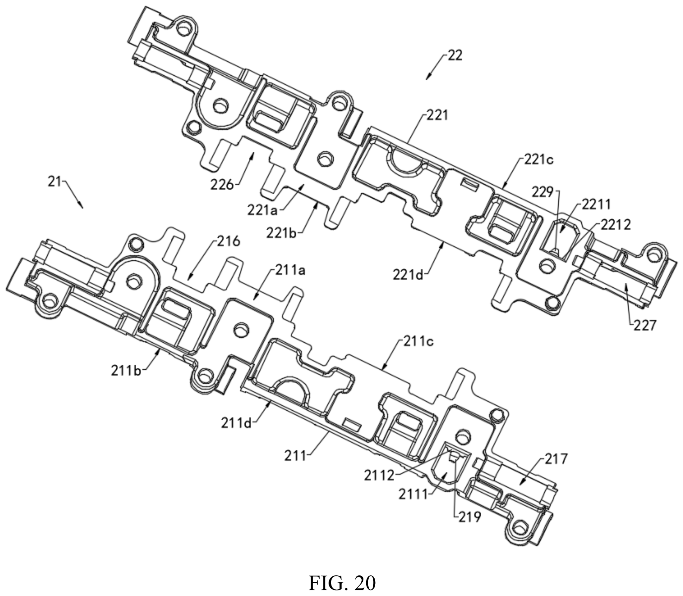

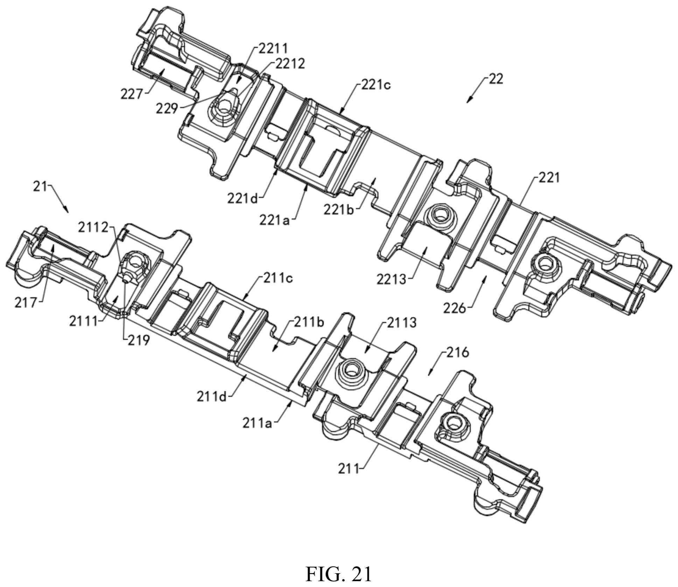

FIG. 20 is a diagram of structures of a first fastening bracket 21 and a second fastening bracket 22 shown in FIG. 11 from another angle. FIG. 21 is a diagram of structures of the first fastening bracket 21 and the second fastening bracket 22 shown in FIG. 20 from another angle.

As shown in FIG. 20 and FIG. 21, the first fastening bracket body 211 includes a top surface 211a and a bottom surface 211b that are disposed back to back, and a right side surface 211c (also referred to as a first side surface) and a left side surface 211d (also referred to as a second side surface) that are disposed back to back. The top surface 211a and the bottom surface 211b of the first fastening bracket body 211 are connected between the right side surface 211c and the left side surface 211d of the first fastening bracket body 211. It may be understood that the right side surface 211c of the first fastening bracket body 211 is disposed facing the main shaft 1.

For example, the first fastening bracket body 211 is provided with a first mounting hole 2111. The first mounting hole 2111 may be spaced from the sliding space 216 and the rotation space 217 of the first fastening bracket 21. The first mounting hole 2111 penetrates from the top surface 211a of the first fastening bracket body 211 to the bottom surface 211b of the first fastening bracket body 211. The first mounting hole 2111 has a first hole wall 2112. The first hole wall 2112 faces the left side surface 211d of the first fastening bracket body 211. It may be understood that a shape, a size, a quantity, and a location of the first mounting hole 2111 are not specifically limited in this application.

For example, the first fastening bracket 21 includes a first guide block 219. The first guide block 219 protrudes from the first hole wall 2112. It may be understood that the first guide block 219 may be a shape combining a circular truncated cone and a cylinder. In another implementation, the first guide block 219 may alternatively be in another shape, for example, a circular truncated cone or a cylinder. This is not specifically limited in this application.

As shown in FIG. 21, the first fastening bracket body 211 is provided with a first accommodation groove 2113. The first accommodation groove 2113 may form an opening on the bottom surface 211b of the first fastening bracket body 211. It may be understood that a shape, a size, a quantity, and a location of the first accommodation groove 2113 are not specifically limited in this application.

As shown in FIG. 20 and FIG. 21, the second fastening bracket body 221 includes a top surface 221a and a bottom surface 221b that are disposed back to back, and a right side surface 221c (also referred to as a second side surface) and a left side surface 221d (also referred to as a second side surface) that are disposed back to back. The top surface 221a and the bottom surface 221b of the second fastening bracket body 221 are connected between the right side surface 221c and the left side surface 221d of the second fastening bracket body 221. It may be understood that the left side surface 221d of the second fastening bracket body 221 is disposed facing the main shaft 1.

For example, the second fastening bracket body 221 is provided with a second mounting hole 2211. The second mounting hole 2211 may be spaced from a sliding space 226 and a rotation space 227 of the second fastening bracket 22. The second mounting hole 2211 penetrates from the top surface 221a of the second fastening bracket body 221 to the bottom surface 221b of the second fastening bracket body 221. The second mounting hole 2211 has a second hole wall 2212. The second hole wall 2212 faces the right side surface 221c of the second fastening bracket body 221. It may be understood that a shape, a size, a quantity, and a location of the second mounting hole 2211 are not specifically limited in this application.

For example, the second fastening bracket 22 includes a second guide block 229. The second guide block 229 protrudes from the second hole wall 2212. It may be understood that the second guide block 229 may be a shape combining a circular truncated cone and a cylinder. In another implementation, the second guide block 229 may alternatively be in another shape, for example, a circular truncated cone or a cylinder. This is not specifically limited in this application.

As shown in FIG. 21, the second fastening bracket body 221 is provided with a second accommodation groove 2213. The second accommodation groove 2213 may form an opening on the bottom surface 221b of the second fastening bracket body 221. It may be understood that a shape, a size, a quantity, and a location of the second accommodation groove 2213 are not specifically limited in this application.

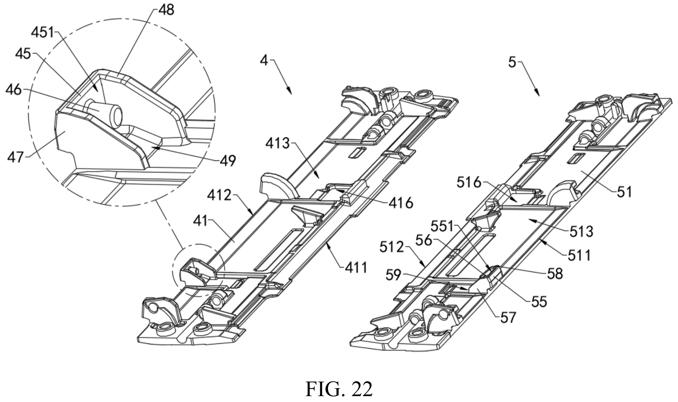

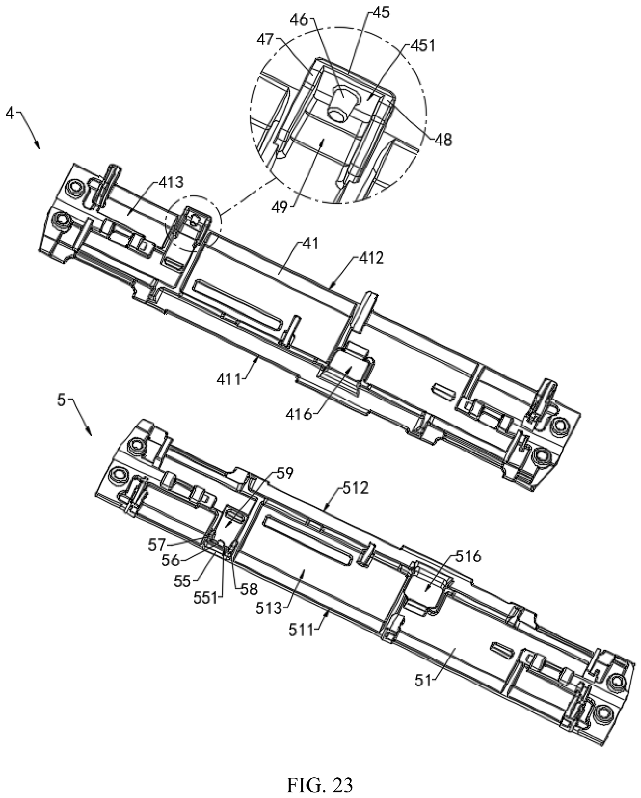

FIG. 22 is an enlarged diagram of an implementation of the first support plate 4 and the second support plate 5 shown in FIG. 15. FIG. 23 is a diagram of structures of the first support plate 4 and the second support plate 5 shown in FIG. 22 from another angle.

As shown in FIG. 22 and FIG. 23, the first support plate 4 includes a first connection plate 45 and a first mounting block 46. The first connection plate 45 protrudes from the first fastening surface 413 of the first support plate body 41. The first connection plate 45 includes a first connection surface 451. The first connection surface 451 faces the right side surface 411 of the first support plate body 41.

For example, the first connection plate 45 is disposed close to the left side surface 412 of the first support plate body 411 relative to the right side surface 411 of the first support plate body 41. For example, the first connection plate 45 may be further connected to the left side surface 412 of the first support plate body 41.

For example, the first mounting block 46 protrudes from the first connection surface 451. It may be understood that a shape of the first mounting block 46 may be a cylinder. In another implementation, the first mounting block 46 may alternatively be in another shape, for example, a circular truncated cone or a combination of a circular truncated cone and a cylinder. This is not specifically limited in this application.

For example, the first support plate 4 further includes a first baffle plate 47 and a second baffle plate 48. Both the first baffle plate 47 and the second baffle plate 48 protrude from the first fastening surface 413 of the first support plate body 41. The first baffle plate 47 and the second baffle plate 48 may be connected to two ends of the first connection plate 45, and are located on a same side of the first connection plate 45. In this case, the first baffle plate 47, the second baffle plate 48, and the first connection plate 45 enclose a first groove 49. The first mounting block 46 is located in the first groove 49, that is, the first mounting block 46 is located between the first baffle plate 47 and the second baffle plate 48.

As shown in FIG. 22 and FIG. 23, the first support plate body 41 is provided with a first accommodation groove 416. The first accommodation groove 416 may form an opening on the first fastening surface 413 of the first support plate body 41. It may be understood that a shape, a size, a quantity, and a location of the first accommodation groove are not specifically limited in this application.

As shown in FIG. 22 and FIG. 23, the second support plate 5 includes a second connection plate 55 and a second mounting block 56. The second connection plate 55 protrudes from a second fastening surface 513 of the second support plate body 51. The second connection plate 55 includes a second connection surface 551. The second connection surface 551 faces the left side surface 512 of the second support plate body 51.

For example, the second connection plate 55 is disposed close to the right side surface 511 of the second support plate body 51 relative to the left side surface 512 of the second support plate body 51. For example, the second connection plate 55 may be further connected to the right side surface 511 of the second support plate body 51.

For example, the second mounting block 56 protrudes from the second connection surface 551. It may be understood that a shape of the second mounting block 56 may be a cylinder. In another implementation, the second mounting block 56 may alternatively be in another shape, for example, a circular truncated cone or a combination of a circular truncated cone and a cylinder. This is not specifically limited in this application.

For example, the second support plate 5 further includes a third baffle plate 57 and a fourth baffle plate 58. The third baffle plate 57 and the fourth baffle plate 58 may be connected to two ends of the second connection plate 55, and are located on a same side of the second connection plate 55. In this case, the third baffle plate 57, the fourth baffle plate 58, and the second connection plate 55 enclose a second groove 59. The second mounting block 56 is located in the second groove 59, that is, the second mounting block 56 is located between the third baffle plate 57 and the fourth baffle plate 58.

As shown in FIG. 22 and FIG. 23, the second support plate body 51 is provided with a second accommodation groove 516. The second accommodation groove 516 may form an opening on the second fastening surface 513 of the second support plate body 51. It may be understood that a shape, a size, a quantity, and a location of the second accommodation groove 516 are not specifically limited in this application.

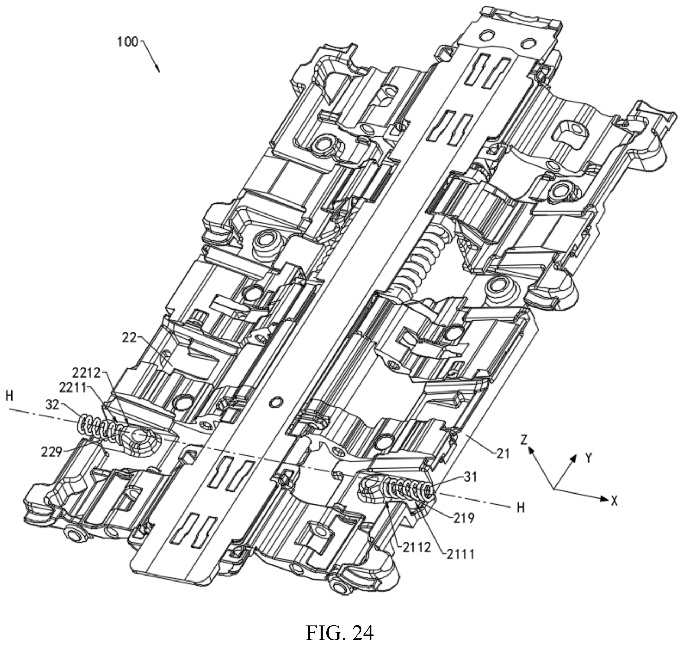

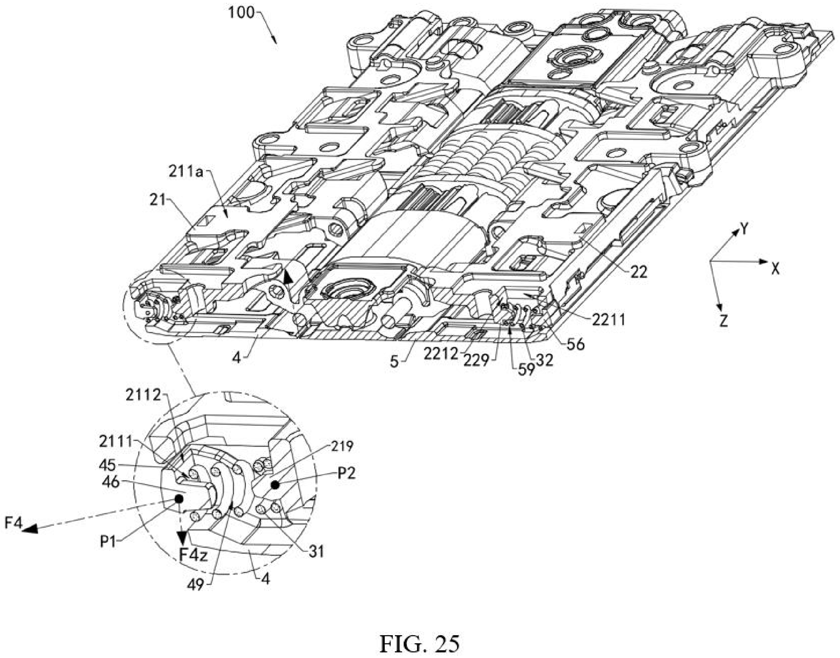

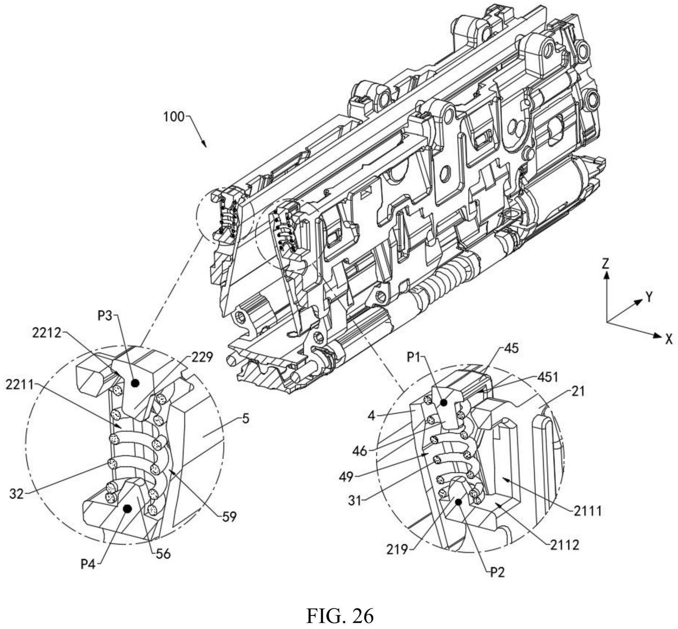

FIG. 24 is a diagram of a partial structure of the folding mechanism 100 shown in FIG. 7 from another angle. FIG. 25 is a partial sectional view of an implementation of the folding mechanism 100 shown in FIG. 24 at a line H-H. FIG. 26 is a partial sectional view of an implementation of a folding mechanism 100 shown in FIG. 19 at a line I-I.

As shown in FIG. 24 to FIG. 26, for example, the first elastic member 31 and the second elastic member 32 may be springs, spring plates, or elastic mechanical parts. This is not specifically limited in this application. In this implementation, the first elastic member 31 and the second elastic member 32 each are described by using a spring as an example.

As shown in FIG. 24 to FIG. 26, the first elastic member 31 is connected to the first fastening bracket 21 and the first support plate 4. For example, one end of the first elastic member 31 is sleeved on the first guide block 219 of the first fastening bracket 21, and abuts against the first hole wall 2112 of the first mounting hole 2111 of the first fastening bracket 21. The other end of the first elastic member 31 is sleeved on the first mounting block 46 of the first support plate 4, and abuts against the first connection plate 45 of the first support plate 4.

It may be understood that a part of the first elastic member 31 is located in the first mounting hole 2111 of the first fastening bracket 21, and a part of the first elastic member 31 is located in the first groove 49 of the first support plate 4. In this way, the first fastening bracket 21, the first connection plate 45, the first baffle plate 47, and the second baffle plate 48 can be configured to: protect the first elastic member 31 and prevent the first elastic member 31 from interference with another mechanical part.

As shown in FIG. 26, for example, when the electronic device 1000 is in a folded state, the first guide block 219 of the first fastening bracket 21 is disposed opposite to the first mounting block 46 of the first support plate 4. In this way, the first guide block 219 and the first mounting block 46 can better guide a deformation direction of the first elastic member 31, to avoid damage to the first elastic member 31 due to deformation. In another implementation, when the electronic device 1000 is in an unfolded state or any other state, the first guide block 219 of the first fastening bracket 21 may also be disposed opposite to the first mounting block 46 of the first support plate 4. In this way, the first guide block 219 and the first mounting block 46 can always guide the deformation direction of the first elastic member 31, to avoid damage to the first elastic member 31 due to deformation. In another implementation, when the electronic device 1000 is in a folded state, the first guide block 219 of the first fastening bracket 21 may not be disposed opposite to the first mounting block 46 of the first support plate 4.

As shown in FIG. 26, for example, when the electronic device 1000 is in a folded state, the first mounting block 46 may be at least partially located in the first mounting hole 2111. In this way, the first mounting block 46 and the first fastening bracket 21 have an overlapping area in a thickness direction of the first fastening bracket 21, so that arrangement between the first fastening bracket 21 and the first support plate 4 is more compact. This helps improve space utilization of the folding mechanism 100. In another implementation, when the electronic device 1000 is in an unfolded state or any other state, the first mounting block 46 may be at least partially located in the first mounting hole 2111. In another implementation, when the electronic device 1000 is in a folded state, the first mounting block 46 may not be at least partially located in the first mounting hole 2111.

As shown in FIG. 26, for example, the first connection plate 45 may be at least partially located in the first mounting hole 2111. In this way, the first connection plate 45 and the first fastening bracket 21 have an overlapping area in a thickness direction of the first fastening bracket 21, so that arrangement between the first fastening bracket 21 and the first support plate 4 is more compact. This helps improve space utilization of the folding mechanism 100. In another implementation, when the electronic device 1000 is in an unfolded state or any other state, the first connection plate 45 may be at least partially located in the first mounting hole 2111. In another implementation, when the electronic device 1000 is in a folded state, the first connection plate 45 may not be at least partially located in the first mounting hole 2111.

It may be understood that, in comparison with a solution in which the first mounting block 46 directly protrudes from the first fastening surface 413, as shown in FIG. 25 and FIG. 26, in this implementation, the first connection plate 45 is disposed, and the first mounting block 46 protrudes from the first connection surface 451 of the first connection plate 45, so that a distance between the first mounting block 46 and the first fastening surface 413 can be increased, and the first mounting block 46 can be more readily disposed opposite to the first guide block 219.

It may be understood that, in comparison with a solution in which the first guide block 219 directly protrudes from the top surface 211a of the first fastening bracket 21, as shown in FIG. 25, in this implementation, the first fastening bracket 21 is provided with the first mounting hole 2111, and the first guide block 219 protrudes from the first hole wall 2112 of the first mounting hole 2111, so that a distance between the first guide block 219 and the first support plate 4 can be reduced, and the first guide block 219 can be more readily disposed opposite to the first mounting block 46.

It may be understood that, the first mounting block 46 is at least partially disposed in the first mounting hole 2111, so that the first mounting block 46 and the first fastening bracket 21 have the overlapping area in the thickness direction of the first fastening bracket 21. This helps improve space utilization.

In another implementation, a connection manner of the first elastic member 31 and the first fastening bracket 21 and a manner connection of the first elastic member 31 and the first support plate 4 are not specifically limited in this application.

It may be understood that a location of the first guide block 219 of the first fastening bracket 21, a height of the first connection plate 45 of the first support plate 4, and a location of the first mounting block 46 of the first support plate 4 may be adjusted, so that regardless of whether the electronic device 1000 is in an unfolded state or a folded state, the first guide block 219 of the first fastening bracket 21 and the first mounting block 46 of the first support plate 4 can be disposed opposite to each other. In this way, the first elastic member 31 is not prone to damage due to deformation.

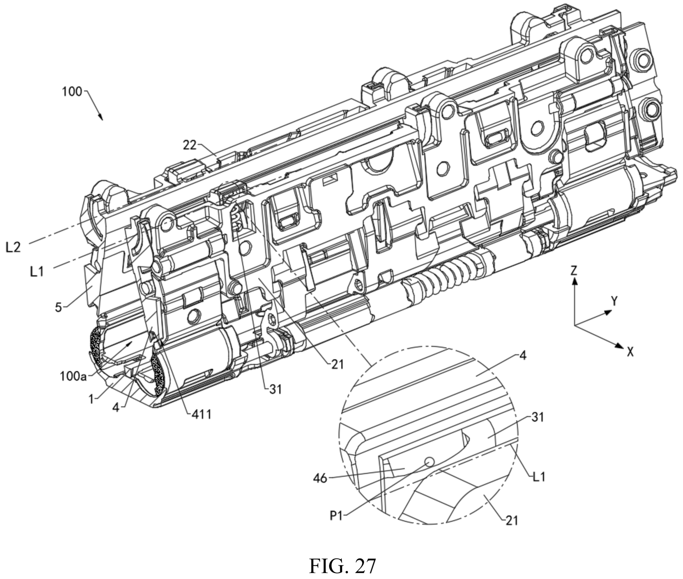

FIG. 27 is a partial sectional view of an implementation of a folding mechanism 100 shown in FIG. 19 at a line J-J.

As shown in FIG. 26 and FIG. 27, the first elastic member 31 is in a compressed state. In this case, the first elastic member 31 may apply an elastic force to the first support plate 4 and the first fastening bracket 21.

As shown in FIG. 26 and FIG. 27, for example, a point of application of force of the first elastic member 31 on the first support plate 4 is a first point of application of force P1. The first point of application of force P1 may be a center of a contact location between the first elastic member 31 and the first support plate 4. It may be understood that, in general, the first elastic member 31 and the first support plate 4 apply an acting force through surface-to-surface contact. Therefore, all the contact location between the first elastic member 31 and the first support plate 4 may be points of application of force. In this case, there are a plurality of points of application of force between the first elastic member 31 and the first support plate 4. In this implementation, for ease of understanding and description of the solution, the following uses the center of the contact location between the first elastic member 31 and the first support plate 4 as an example for description.

As shown in FIG. 26 and FIG. 27, for example, a point of application of force of the first elastic member 31 on the first fastening bracket 21 is a second point of application of force P2. It may be understood that the point of application of force of the first elastic member 31 on the first fastening bracket 21 may be a center of a contact location between the first elastic member 31 and the first fastening bracket 21.

In addition, it can be learned from the foregoing that the first support plate 4 is rotatably connected to the first fastening bracket 21. An axis of rotation of the first support plate 4 relative to the first fastening bracket 21 is a first rotation axis L1.

As shown in FIG. 27, the first point of application of force P1 is located on a side that is of the first rotation axis L1 and that is away from the main shaft 1. In other words, the first rotation axis L1 is closer to the main shaft 1 relative to the first point of application of force P1.

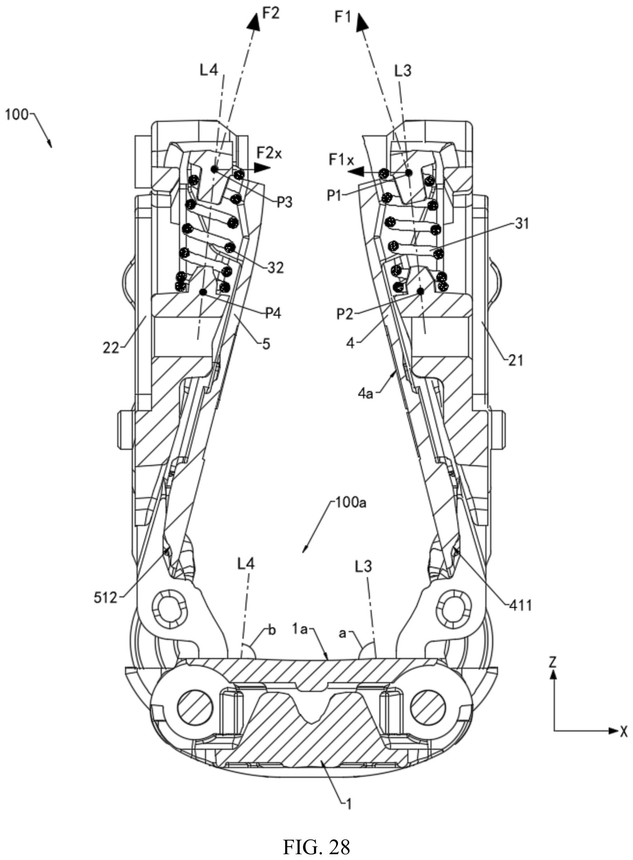

FIG. 28 is a diagram of a structure of the folding mechanism 100 shown in FIG. 27 from another angle.

As shown in FIG. 28, when the folding mechanism 100 is in a folded state, a first included angle a formed between the first support surface 1a and a connection line L3 between the first point of application of force P1 and the second point of application of force P2 in the negative direction of the X-axis is an acute angle. In other words, the connection line between the first point of application of force P1 and the second point of application of force P2 is disposed obliquely relative to the first support surface 1a, that is, the first elastic member 31 is disposed obliquely relative to the first support surface 1a. It may be understood that, to more clearly show the first included angle a, in FIG. 28, the connection line L3 between the first point of application of force P1 and the second point of application of force P2 is schematically moved to the first support surface 1a, and forms the first included angle a with the first support surface 1a.

Refer to FIG. 28. With reference to FIG. 26 and FIG. 27, when the folding mechanism 100 is in a folded state, because the first elastic member 31 is in a compressed state, the first elastic member 31 may apply a first acting force F1 to the first support plate 4 (FIG. 28 schematically shows a direction of an implementation of the first acting force F1 by using a dashed line with an arrow). Because the first included angle a formed between the first support surface 1a and the connection line between the first point of application of force P1 and the second point of application of force P2 is an acute angle, the first acting force F1 may generate a first component force F1x in the negative direction of the X-axis (FIG. 28 schematically shows a direction of an implementation of the first component force F1x by using a dashed line with an arrow). In addition, because the first point of application of force P1 is located on the side that is of the first rotation axis L1 and that is away from the main shaft 1, the first component force F1x may make the end part that is of the first support plate 4 and that is away from the main shaft 1 (namely, an end part that is of the first support plate 4 and that includes the left side surface 412 of the first support plate 4) approach in a direction close to the second support plate 5. In this case, an acting force in the positive direction of the X-axis may be formed on an end part (namely, an end part that is of the first support plate 4 and that includes the right side surface 411 of the first support plate 4) that is of the first support plate 4 and that is close to the main shaft 1. The end part that is of the first support plate 4 and that is close to the main shaft 1 may expand in a direction away from the second support plate 5. In this way, the screen accommodating space 100a enclosed by the first support plate 4, the main shaft 1, and the second support plate 5 can be greatly increased. When the second display area 202 of the flexible display 200 (refer to FIG. 19) is located in the screen accommodating space 100a, the free deformation space of the second display area 202 of the flexible display 200 is released, and the bending degree of the second display area 202 of the flexible display 200 may be small. In this case, the second display area 202 of the flexible display 200 is not prone to damage, and reliability of the flexible display 200 is good. Particularly, when the electronic device 1000 is in an unconventional environment like suffering a fall or an impact, the folding mechanism 100 is not prone to squeeze the flexible display 200, and the flexible display 200 is not prone to failure or the like. In addition, when the end part that is of the first support plate 4 and that is close to the main shaft 1 expands in the direction away from the second support plate 5, the first support plate 4 may also drive some parts (for example, the first fastening bracket 21, the first gear connecting rod 25, the first rotation member 27a, and the damping member 28) of the folding mechanism 100 to move slightly, to reduce a gap between some parts. In addition, the folding mechanism 100 is more compact, and space utilization is higher.

It may be understood that there is a solution in which the first elastic member 31 is not disposed in the folding mechanism 100. After the electronic device 1000 is folded many times, due to part wear of the folding mechanism 100 and spring attenuation of the damping member 28, the damping force decreases, and a retraction force of the flexible display 200 (refer to FIG. 19) drives the first support plate 4 and the second support plate 5 to rotate relative to the main shaft 1, causing reducing of the screen accommodating space 100a. In addition, the retraction force of the flexible display 200 and gravity of the flexible display 200 may also drive the first support plate 4 and the second support plate 5 to fall toward the main shaft 1, further causing reducing of the screen accommodating space 100a. In this implementation, the first elastic member 31 is disposed between the first fastening bracket 21 and the first support plate 4, and an elastic force of the first elastic member 31 is used to cause the end part that is of the first support plate 4 and that is close to the main shaft 1 to expand, to greatly increase the size of the screen accommodating space 100a. In this way, a problem that the screen accommodating space 100a is reduced due to the retraction force of the flexible display 200 driving the first support plate 4 and the second support plate 5 to rotate relative to the main shaft 1 after the electronic device 1000 is folded many times can be resolved, and in addition, a problem that the screen accommodating space 100a is reduced due to the retraction force of the flexible display 200 and the gravity of the flexible display 200 driving the first support plate 4 and the second support plate 5 to fall toward the main shaft 1 after the electronic device 1000 is folded many times can be resolved.

Refer to FIG. 28. With reference to FIG. 26 and FIG. 27, in an implementation, the contact location between the first elastic member 31 and the first support plate 4 is located on the side that is of the first rotation axis L1 and that is away from the main shaft 1.

It may be understood that the first point of application of force P1 may be the center of the contact location between the first elastic member 31 and the first support plate 4. In this way, when the contact location between the first elastic member 31 and the first support plate 4 is located on the side that is of the first rotation axis L1 and that is away from the main shaft 1, it can be ensured that the first point of application of force P1 is always located on the side that is of the first rotation axis L1 and that is away from the main shaft 1. In this case, the first component force F1x may always cause the end part that is of the first support plate 4 and that is away from the main shaft 1 to approach the direction close to the second support plate 5, and the end part that is of the first support plate 4 and that is close to the main shaft 1 may expand in the direction away from the second support plate 5.

It may be understood that, when the electronic device 1000 is in a folded state, a magnitude of the elastic force applied by the first elastic member 31 to the first support plate 4 may be adjusted by using first elastic members 31 of different materials, first elastic members 31 of different elastic coefficients, or the like, so that an opening angle of the first support plate 4 is adjusted to different extents, to better control the size of the screen accommodating space 100a.

As shown in FIG. 25, when the folding mechanism 100 is in an unfolded state, the first point of application of force P1 is disposed close to the second support surface 4a relative to the second point of application of force P2. In other words, when the folding mechanism 100 is in an unfolded state, an included angle formed between the second support surface 4a and the connection line between the first point of application of force P1 and the second point of application of force P2 is an acute angle, that is, the first elastic member 31 is disposed obliquely relative to the second support surface 4a.

It may be understood that, because the first elastic member 31 is in a compressed state, the first elastic member 31 may apply a fourth acting force F4 to the first support plate 4 (FIG. 25 schematically shows a direction of an implementation of the fourth acting force F4 by using a dashed line with an arrow). Because the first point of application of force P1 is disposed close to the second support surface 4a relative to the second point of application of force P2, the fourth acting force F4 may generate a fourth component force F4z in the positive direction of the Z-axis. In addition, because the first point of application of force P1 is located on the side that is of the first rotation axis L1 (refer to FIG. 27) and that is away from the main shaft 1, the fourth component force F4z may make the end part that is of the first support plate 4 and that is close to the main shaft 1 generate an acting force in the negative direction of the Z-axis. The end part that is of the first support plate 4 and that is close to the main shaft 1 has a trend of moving in the negative direction of the Z-axis (FIG. 25 schematically shows a movement trend of the end part that is of the first support plate 4 and that is close to the main shaft 1 by using a dashed line with an arrow), to ensure that the end part that is of the first support plate 4 and that is close to the main shaft 1 may not rise in the positive direction of the Z-axis, and further ensure that the end part that is of the first support plate 4 and that is close to the main shaft 1 may not cause damage or failure to the flexible display 200 due to abutting against the flexible display 200.

As shown in FIG. 24 to FIG. 28, for example, the second elastic member 32 is connected to the second fastening bracket 22 and the second support plate 5. For a connection manner of the second elastic member 32 and the second fastening bracket 22 and a connection manner of the second elastic member 32 and the second support plate 5, refer to the connection manner of the first elastic member 31 and the first fastening bracket 21 and the connection manner of the first elastic member 31 and the first support plate 4. For example, one end of the second elastic member 32 is sleeved on the second guide block 229 of the second fastening bracket 22, and abuts against the second hole wall 2212 of the second mounting hole 2211 of the second fastening bracket 22. The other end of the second elastic member 32 is sleeved on the second mounting block 56 of the second support plate 5, and abuts against the second connection plate 55 of the second support plate 5. Details are not described herein again.

In this implementation, the second elastic member 32 is in a compressed state. In this case, the second elastic member 32 may apply an elastic force to the second support plate 5 and the second fastening bracket 22. A point of application of force of the second elastic member 32 on the second support plate 5 is a third point of application of force P3. It may be understood that the third point of application of force P3 may be a center of a contact location between the second elastic member 32 and the second support plate 5.

For example, a point of application of force of the second elastic member 32 on the second fastening bracket 22 is a fourth point of application of force P4. It may be understood that the fourth point of application of force P4 may be a center of a contact location between the second elastic member 32 and the second fastening bracket 22.

In addition, it can be learned from the foregoing that the second support plate 5 is rotatably connected to the second fastening bracket 22. An axis of rotation of the second support plate 5 relative to the second fastening bracket 22 is a second rotation axis L2.

As shown in FIG. 27 and FIG. 28, the third point of application of force P3 is located on a side that is of the second rotation axis L2 and that is away from the main shaft 1. In other words, the second rotation axis L2 is closer to the main shaft 1 relative to the third point of application of force P3.

As shown in FIG. 28, when the folding mechanism 100 is in a folded state, a second included angle b formed between the first support surface 1a and a connection line L4 between the third point of application of force P3 and the fourth point of application of force P4 in the positive direction of the X-axis is an acute angle. In other words, the connection line L4 between the third point of application of force P3 and the fourth point of application of force P4 is disposed obliquely relative to the first support surface 1a, that is, the second elastic member 32 is disposed obliquely relative to the first support surface 1a. It may be understood that, to more clearly show the second included angle b, in FIG. 28, the connection line L4 between the third point of application of force P3 and the fourth point of application of force P4 is schematically moved to the first support surface 1a, and forms the second included angle b with the first support surface 1a.

As shown in FIG. 28, when the folding mechanism 100 is in a folded state, because the second elastic member 32 is in a compressed state, the second elastic member 32 applies a second acting force F2 to the second support plate 5 (FIG. 28 schematically shows a direction of an implementation of the second acting force F2 by using a dashed line with an arrow). Because the second included angle b formed between the first support surface 1a and the connection line between the third point of application of force P3 and the fourth point of application of force P4 is an acute angle, the second acting force F2 may generate a second component force F2x in the positive direction of the X-axis (FIG. 28 schematically shows a direction of an implementation of the second acting force F2x by using a dashed line with an arrow). In addition, because the third point of application of force P3 is located on the side that is of the second rotation axis line L2 and that is away from the main shaft 1, the second component force F2x may make the end part that is of the second support plate 5 and that is away from the main shaft 1 (namely, an end part that is of the second support plate 5 and that includes the right side surface 511 of the second support plate 5) approach in a direction close to the first support plate 4. In this case, an acting force in the negative direction of the X-axis may be formed on the end part that is of the second support plate 5 and that is close to the main shaft 1 (namely, an end part that is of the second support plate 5 and that includes the left side surface 512 of the second support plate 5), and the end part that is of the second support plate 5 and that is close to the main shaft 1 expands in a direction away from the first support plate 4. In this way, the screen accommodating space 100a enclosed by the first support plate 4, the main shaft 1, and the second support plate 5 can be further increased. When the second display area 202 of the flexible display 200 (refer to FIG. 19) is located in the screen accommodating space 100a, the free deformation space of the second display area 202 of the flexible display 200 is better released, and the bending degree of the second display area 202 of the flexible display 200 may be small. In this case, the second display area 202 of the flexible display 200 is not prone to damage, and reliability of the flexible display 200 is good. Particularly, when the electronic device 1000 is in an unconventional environment like suffering a fall or an impact, the folding mechanism 100 is not prone to squeeze the flexible display 200, and the flexible display 200 is not prone to failure or the like. In addition, when the end part that is of the second support plate 5 and that is close to the main shaft 1 expands in the direction away from the first support plate 4, the second support plate 5 may also drive some parts (for example, the second fastening bracket 22, the second gear connecting rod 26, the second rotation member 27b, and the damping member 28) of the folding mechanism 100 to move slightly, to reduce a gap between parts. In addition, the folding mechanism 100 is more compact, and space utilization is higher.

In this implementation, the second elastic member 32 is disposed between the second fastening bracket 22 and the second support plate 5, and the elastic force of the second elastic member 32 is used to cause the end part that is of the second support plate 5 and that is close to the main shaft 1 to expand, to greatly increase the size of the screen accommodating space 100a. In this way, the problem that the screen accommodating space 100a is reduced due to the retraction force of the flexible display 200 (refer to FIG. 19) driving the first support plate 4 and the second support plate 5 to rotate relative to the main shaft 1 after the electronic device 1000 is folded many times can be resolved, and in addition, the problem that the screen accommodating space 100a is reduced due to the retraction force of the flexible display 200 and the gravity of the flexible display 200 driving the first support plate 4 and the second support plate 5 to fall toward the main shaft 1 after the electronic device 1000 is folded many times can be resolved.

As shown in FIG. 28, the contact location between the second elastic member 32 and the second support plate 5 is located on the side that is of the second rotation axis L2 and that is away from the main shaft 1.

It may be understood that the third point of application of force P3 may be the center of the contact location between the second elastic member 32 and the second support plate 5. In this way, when the contact location between the second elastic member 32 and the second support plate 5 is located on the side that is of the second rotation axis L2 and that is away from the main shaft 1, it can be ensured that the third point of application of force P3 is always located on the side that is of the second rotation axis L2 and that is away from the main shaft 1. In this case, the second component force F2x may make the end part that is of the second support plate 5 and that is away from the main shaft 1 approach the direction close to the first support plate 4, and the end part that is of the second support plate 5 and that is close to the main shaft 1 expands in the direction away from the first support plate 4.

It may be understood that, when the electronic device 1000 is in a folded state, a magnitude of the elastic force applied by the second elastic member 32 to the second support plate 5 may be adjusted by using second elastic members 32 of different materials, second elastic members 32 of different elastic coefficients, or the like, so that an opening angle of the second support plate 5 is adjusted to different extents, to better control the size of the screen accommodating space 100a.

As shown in FIG. 25, when the folding mechanism 100 is in an unfolded state, a location relationship between the third point of application of force P3 and the fourth point of application of force P4 may also refer to a location relationship between the first point of application of force P1 and the second point of application of force P2. Details are not described herein again.

It may be understood that, in the foregoing, in the specific implementation content and in the accompanying drawings of the specification, that the first point of application of force P1 is located on a side that is of the second point of application of force P2 and that is away from the main shaft 1 is used as an example for description. In another implementation, locations of the first point of application of force P1 and the second point of application of force P2 may also be exchanged. In this case, when the first included angle a formed between the first support surface 1a and the connection line L3 between the first point of application of force P1 and the second point of application of force P2 in the first direction (namely, the negative direction of the X-axis) is an acute angle, the end part that is of the first support plate 4 and that is close to the main shaft 1 may also expand in the direction away from the second support plate 5, and the screen accommodating space 100a enclosed by the first support plate 4, the main shaft 1, and the second support plate 5 may also be greatly increased. This is not specifically limited in this application. Similarly, the third point of application of force P3 and the fourth point of application of force P4 may also be disposed in a same manner. Details are not described herein again.

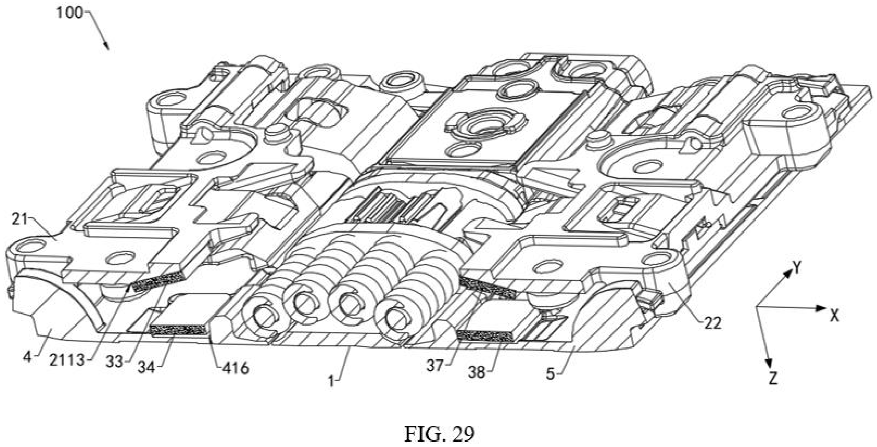

FIG. 29 is a partial sectional view of an implementation of the folding mechanism 100 shown in FIG. 16 at a line K-K.

As shown in FIG. 29, for example, the first attraction member 33 and the second attraction member 34 may be two magnets that can attract each other, or may be a coil and a magnet that can attract each other, or may be two other structures that can attract each other. This is not specifically limited in this application. In this implementation, the first attraction member 33 and the second attraction member 34 are described by using two magnets that can attract each other as an example. It may be understood that shapes, sizes, and quantities of the first attraction member 33 and the second attraction member 34 are not specifically limited in this application.

As shown in FIG. 29, the first attraction member 33 is fastened to the first fastening bracket 21. In an implementation, the first attraction member 33 is at least partially located in the first accommodation groove 2113 of the first fastening bracket 21. For example, the first attraction member 33 may be fastened to a bottom wall of the first accommodation groove 2113 in a fastening manner like adhesive bonding. It may be understood that the first attraction member 33 and the first fastening bracket 21 have an overlapping area, so that the first attraction member 33 and the first fastening bracket 21 are arranged more compactly, and space utilization is higher.

As shown in FIG. 29, the second attraction member 34 is fastened to the first support plate 4. In an implementation, the second attraction member 34 is at least partially located in the first accommodation groove 416 of the first support plate 4. For example, the second attraction member 34 may be fastened to a bottom wall of the first accommodation groove 416 in a fastening manner like adhesive bonding. It may be understood that the second attraction member 34 and the first support plate 4 have an overlapping area, so that the second attraction member 34 and the first support plate 4 are arranged more compactly, and space utilization is higher.

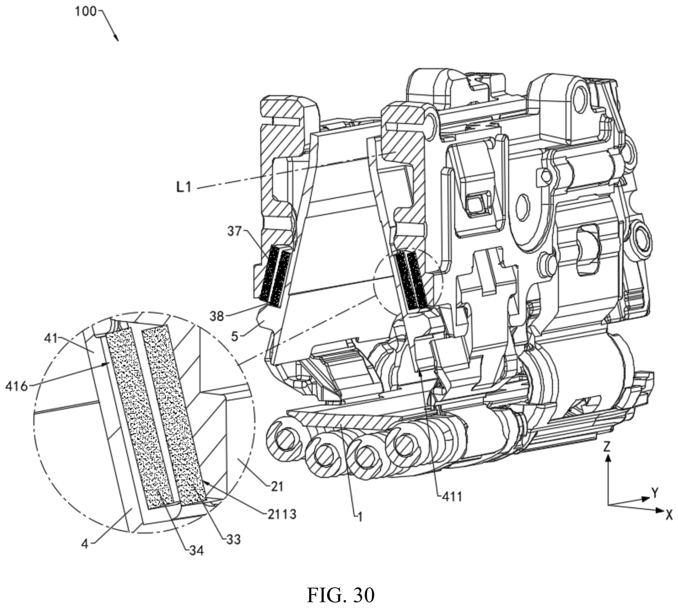

FIG. 30 is a diagram of a structure of an implementation of the folding mechanism 100 shown in FIG. 29 in a folded state.

As shown in FIG. 30, when the folding mechanism 100 is in a folded state, an attraction force may be generated between the first attraction member 33 and the second attraction member 34. In this way, the attraction force generated between the first attraction member 33 and the second attraction member 34 may act on the first support plate 4. For example, the first attraction member 33 and the second attraction member 34 may be disposed opposite to each other. A magnetic polarity of a part that is of the first attraction member 33 and that faces the second attraction member 34 is different from a magnetic polarity of a part that is of the second attraction member 34 and that faces the first attraction member 33. For example, the magnetic polarity of the part that is of the first attraction member 33 and that faces the second attraction member 34 is a south pole, and the magnetic polarity of the part that is of the second attraction member 34 and that faces the first attraction member 33 is a north pole. Alternatively, the magnetic polarity of the part that is of the first attraction member 33 and that faces the second attraction member 34 is a north pole, and the magnetic polarity of the part that is of the second attraction member 34 and that faces the first attraction member 33 is a south pole.

As shown in FIG. 30, the second attraction member 34 is located on a side that is of the first rotation axis L1 and that is close to the main shaft 1. In other words, the second attraction member 34 is closer to the main shaft 1 relative to the first rotation axis L1.

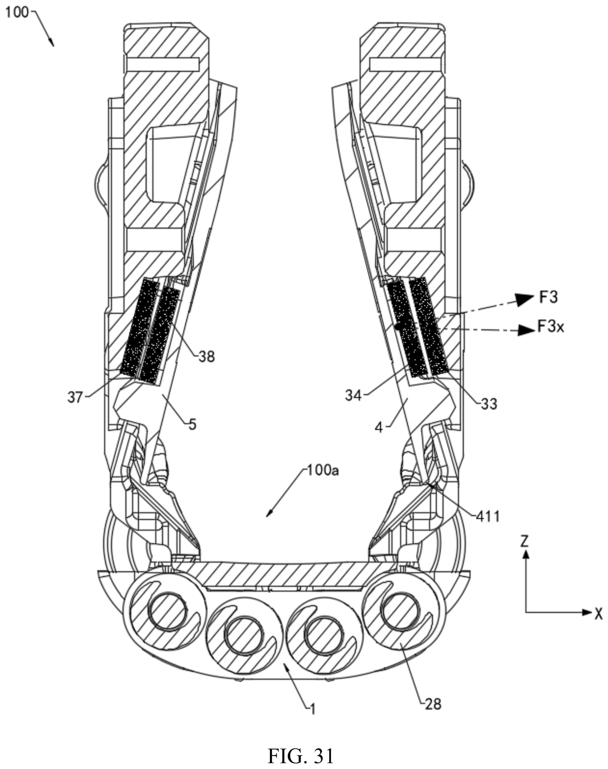

FIG. 31 is a diagram of a structure of the folding mechanism 100 shown in FIG. 30 from another angle.

As shown in FIG. 30 and FIG. 31, when the folding mechanism 100 is in a folded state, the attraction force between the first attraction member 33 and the second attraction member 34 may apply a third acting force F3 to the first support plate 4 (FIG. 30 schematically shows a direction of an implementation of the third acting force F3 by using a dashed line with an arrow). The third acting force F3 may form a third component force F3x in the positive direction of the X-axis on the end part that is of the first support plate 4 and that is close to the main shaft 1 (namely, the end part that is of the first support plate 4 and that includes the right side surface 411 of the first support plate 41). Because the second attraction member 34 is located on the side that is of the first rotation axis line L1 and that is close to the main shaft 1, the third component force F3x may cause the end part that is of the first support plate 4 and that is close to the main shaft 1 to expand in the direction away from the second support plate 5. In this way, the screen accommodating space 100a enclosed by the first support plate 4, the main shaft 1, and the second support plate 5 can be greatly increased. When the second display area 202 of the flexible display 200 (refer to FIG. 19) is located in the screen accommodating space 100a, the free deformation space of the second display area 202 of the flexible display 200 is released, and the bending degree of the second display area 202 of the flexible display 200 may be small. In this case, the second display area 202 of the flexible display 200 is not prone to damage, and reliability of the flexible display 200 is good. Particularly, when the electronic device 1000 is in an unconventional environment like suffering a fall or an impact, the folding mechanism 100 is not prone to squeeze the flexible display 200, and the flexible display 200 is not prone to failure or the like. In addition, when the end part that is of the first support plate 4 and that is close to the main shaft 1 expands in the direction away from the second support plate 5, the first support plate 4 may also drive some parts (for example, the first fastening bracket 21, the first gear connecting rod 25, the first rotation member 27a, and the damping member 28) of the folding mechanism 100 to move slightly, to reduce a gap between parts. In addition, the folding mechanism 100 is more compact, and space utilization is higher.

In addition, in this implementation, the first attraction member 33 is disposed on the first fastening bracket 21, the second attraction member 34 is disposed on the first support plate 4, and the attraction force between the first attraction member 33 and the second attraction member 34 is used to cause the end part that is of the first support plate 4 and that is close to the main shaft 1 to expand, to greatly increase the size of the screen accommodating space 100a. In this way, the problem that the screen accommodating space 100a is reduced due to the retraction force of the flexible display 200 driving the first support plate 4 and the second support plate 5 to rotate relative to the main shaft 1 after the electronic device 1000 is folded many times can be resolved, and in addition, the problem that the screen accommodating space 100a is reduced due to the retraction force of the flexible display 200 and the gravity of the flexible display 200 driving the first support plate 4 and the second support plate 5 to fall toward the main shaft 1 after the electronic device 1000 is folded many times can be resolved.

As shown in FIG. 30 and FIG. 31, in an implementation, the first rotation axis L1 is disposed close to the left side surface 412 of the first support plate 4 relative to the right side surface 411 of the first support plate 4. The second attraction member 34 is disposed close to the right side surface 411 of the first support plate 4 relative to the left side surface 412 of the first support plate 4. In this way, the second attraction member 34 can be disposed far away from the first rotation axis L1 to a large extent. In this case, a torque applied by the second attraction member 34 to the first support plate 4 is large.

As shown in FIG. 30 and FIG. 31, in an implementation, when the folding mechanism 100 is in a folded state, a distance between the second attraction member 34 and the first attraction member 33 is a first distance. As shown in FIG. 29, in an implementation, when the folding mechanism 100 is in an unfolded state, the distance between the second attraction member 34 and the first attraction member 33 is a second distance, and the second distance is greater than the first distance. In this way, when the folding mechanism 100 is in an unfolded state, the attraction force between the second attraction member 34 and the first attraction member 33 is small. The attraction force between the second attraction member 34 and the first attraction member 33 is not likely to drive the first support plate 4 to rotate relative to the first fastening bracket 21.

As shown in FIG. 29 to FIG. 31, the third attraction member 37 is fastened to the second fastening bracket 21. The fourth attraction member 38 is fastened to the second support plate 5. The third attraction member 37 is located on a side that is of the second rotation axis line P1 and that is close to the main shaft 1. In addition, when the folding mechanism 100 is in a folded state, an attraction force may be generated between the third attraction member 37 and the fourth attraction member 38. In this case, the attraction force between the third attraction member 37 and the fourth attraction member 38 may be used to cause the end that is of the second support plate 5 and that is close to the main shaft 1 to expand in the direction away from the first support plate 4, and the screen accommodating space 100a enclosed by the first support plate 4, the main shaft 1, and the second support plate 5 may be greatly increased. It may be understood that for a manner of disposing the third attraction member 37 and the fourth attraction member 38, refer to a manner of disposing the first attraction member 33 and the second attraction member 34. Details are not described herein again. In addition, for a location relationship between the fourth attraction member 38 and the second support plate 5, refer to a location relationship between the second attraction member 34 and the first support plate 4. Details are not described herein again.

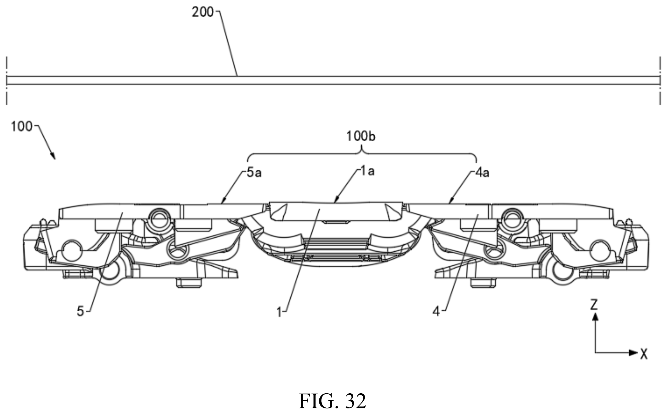

It may be understood that, in the foregoing, the folding mechanism 100 is provided with the first elastic member 31, the second elastic member 32, the first attraction member 33, the second attraction member 34, the third attraction member 37, and the fourth attraction member 38. In another implementation, the folding mechanism 100 may be provided with only the first elastic member 31, and this is used as a complete solution. In this way, the folding mechanism 100 may not be provided with the second elastic member 32, the first attraction member 33, the second attraction member 34, the third attraction member 37, and the fourth attraction member 38. Similarly, the folding mechanism 100 may be provided with only the second elastic member 32, and this is used as a complete solution. The folding mechanism 100 may be provided with only the first attraction member 33 and the second attraction member 34, and this is used as a complete solution. The folding mechanism 100 may be provided with only the third attraction member 37 and the fourth attraction member 38, and this is used as a complete solution. In another implementation, two of the components may be combined (for example, the first elastic member 31 and the second elastic member 32 are combined, or the first elastic member 31 and the first attraction member 33 and the second attraction member 34 are combined), and this is used as a complete solution. Three of the components may be combined (for example, the first elastic member 31, the second elastic member 32, the first attraction member 33, and the second attraction member 34 are combined), and this is used as a complete solution. This is not specifically limited in this application. FIG. 32 is a diagram of partial structures of another implementation of a folding mechanism 100 and a flexible display 200 provided in an implementation of this application.

As shown in FIG. 32, when the folding mechanism 100 is in an unfolded state, the first support surface 1a of the main shaft 1 protrudes relative to the second support surface 4a of the first support plate 4 and the third support surface 5a of the second support plate 5. In other words, relative to the second support surface 4a of the first support plate 4 and the third support surface 5a of the second support plate 5, the first support surface 1a of the main shaft 1 is closer to the flexible display 200 (refer to FIG. 19).

It may be understood that, in a solution, after the electronic device 1000 is folded many times, the retraction force of the flexible display 200 and the gravity of the flexible display 200 drive the first support plate 4 and the second support plate 5 to fall toward the main shaft 1. In this case, when the electronic device 1000 is in an unfolded state, the second display area 202 of the flexible display 200 is recessed toward the main shaft 1 to form an obvious crease, causing a light and shadow problem. However, in this implementation, the first support surface 1a of the main shaft 1 protrudes relative to the second support surface 4a of the first support plate 4 and the third support surface 5a of the second support plate 5, so that the first support surface 1a of the main shaft 1 is closer to the second display area 202 of the flexible display 200. In this way, when the retraction force of the flexible display 200 and the gravity of the flexible display 200 drive the first support plate 4 and the second support plate 5 to fall toward the main shaft, the first support surface 1a of the main shaft 1 can support the second display area 202 of the flexible display 200, to avoid a problem that the second display area 202 of the flexible display 200 forms a crease due to being recessed toward the main shaft 1, so as to avoid the light and shadow problem of the second display area 202 of the flexible display 200.

It may be understood that the implementation shown in FIG. 32 may use the folding mechanism 100 described above, or may not use the folding mechanism 100 described above (for example, the folding mechanism 100 may not be provided with the first elastic member 31, the second elastic member 32, the first attraction member 33, the second attraction member 34, the third attraction member 37, and the fourth attraction member 38). A specific structure of the folding mechanism 100 is not limited in this implementation. It should be noted that embodiments in this application and features in embodiments may be combined with each other without a conflict, and any combination of features in different embodiments also falls within the protection scope of this application. In other words, the foregoing described plurality of embodiments may be further combined based on an actual requirement.

It should be noted that all the foregoing accompanying drawings are example figures of this application, and do not represent actual sizes of products. In addition, a size proportional relationship between parts in the accompanying drawings is not intended to limit an actual product in this application either. The foregoing descriptions are merely some embodiments and implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A folding mechanism (100), comprising a main shaft (1), a first fastening bracket (21), a second fastening bracket (22), a first movable member (23), a second movable member (24), a first support plate (4), a second support plate (5), and a first elastic member (31), wherein the main shaft (1) is located between the first fastening bracket (21) and the second fastening bracket (22);
the first movable member (23) movably connects the main shaft (1) and the first fastening bracket (21), and the second movable member (24) movably connects the main shaft (1) and the second fastening bracket (22);
the first support plate (4) is rotatably connected to the first fastening bracket (21) and movably connected to the first movable member (23), the second support plate (5) is rotatably connected to the second fastening bracket (22) and movably connected to the second movable member (24), when the folding mechanism (100) is in an unfolded state, a first support surface (1a) of the main shaft (1), a second support surface (4a) of the first support plate (4), and a third support surface (5a) of the second support plate (5) jointly form a support surface (100b), and when the folding mechanism (100) is in a folded state, the second support surface (4a) and the third support surface (5a) are disposed opposite to each other, and enclose at least a part of a screen accommodating space (100a) with the first support surface (1a);
the first elastic member (31) connects the first support plate (4) and the first fastening bracket (21), the first elastic member (31) is in a compressed state, a point of application of force of the first elastic member (31) on the first support plate (4) is a first point of application of force (P1), a point of application of force of the first elastic member (31) on the first fastening bracket (21) is a second point of application of force (P2), and an axis of rotation of the first support plate (4) relative to the first fastening bracket (21) is a first rotation axis (L1); and
the first point of application of force (P1) is located on a side that is of the first rotation axis (L1) and that is away from the main shaft (1), and when the folding mechanism (100) is in a folded state, a first included angle (a) formed between the first support surface (1a) and a connection line between the first point of application of force (P1) and the second point of application of force (P2) in a first direction is an acute angle, wherein the first direction is a direction in which the first support plate (4) points to the second support plate (5).

2. The folding mechanism (100) according to claim 1, wherein a contact location between the first elastic member (31) and the first support plate (4) is located on the side that is of the first rotation axis (L1) and that is away from the main shaft (1).

3. The folding mechanism (100) according to claim 1 or 2, wherein the folding mechanism (100) further comprises a second elastic member (32), and the second elastic member (32) connects the second support plate (5) and the second fastening bracket (22);
the second elastic member (32) is in a compressed state, a point of application of force of the second elastic member (32) on the second support plate (5) is a third point of application of force (P3), a point of application of force of the second elastic member (32) on the second fastening bracket (22) is a fourth point of application of force (P4), and an axis of rotation of the second support plate (5) relative to the second fastening bracket (22) is a second rotation axis (L2); and
the third point of application of force (P3) is located on a side that is of the second rotation axis (L2) and that is away from the main shaft (1), and when the folding mechanism (100) is in a folded state, a second included angle (b) formed between the first support surface (1a) and a connection line between the third point of application of force (P3) and the fourth point of application of force (P4) in a second direction is an acute angle, wherein the second direction is opposite to the first direction.

4. The folding mechanism (100) according to claim 1 or 2, wherein the first fastening bracket (21) has a first guide block (219), the first support plate (4) has a first mounting block (46), and the first mounting block (46) is disposed opposite to the first guide block (219); and
the first elastic member (31) is a spring, one end of the first elastic member (31) is sleeved on the first guide block (219) and abuts against the first fastening bracket (21), and the other end of the first elastic member (31) is sleeved on the first mounting block (46) and abuts against the first support plate (4).

5. The folding mechanism (100) according to claim 4, wherein the first fastening bracket (21) is provided with a first mounting hole (2111), and the first mounting hole (2111) penetrates a top surface (211a) and a bottom surface (211b) of the first fastening bracket (21); and
the first guide block (219) protrudes from a hole wall of the first mounting hole (2111), and the first elastic member (31) abuts against the hole wall of the first mounting hole (2111).

6. The folding mechanism (100) according to claim 4, wherein the first support plate (4) comprises a first support plate body (41) and a first connection plate (45), the first support plate body (41) comprises a first fastening surface (413), and the first fastening surface (413) and the second support surface (4a) are disposed back to back; and
the first connection plate (45) protrudes from the first fastening surface (413), the first mounting block (46) protrudes from the first connection plate (45), and the first elastic member (31) abuts against the first connection plate (45).

7. The folding mechanism (100) according to claim 6, wherein the first mounting block (46) is at least partially located inside the first mounting hole (2111).

8. The folding mechanism (100) according to claim 6 or 7, wherein the first support plate (4) further comprises a first baffle plate (47) and a second baffle plate (48), the first baffle plate (47) and the second baffle plate (48) both protrude from the first fastening surface (413), and the first baffle plate (47) and the second baffle plate (48) are further connected to two ends of the first connection plate (45), and are located on a same side of the first connection plate (45); and
the first mounting block (46) is located between the first baffle plate (47) and the second baffle plate (48).

9. The folding mechanism (100) according to any one of claims 1 to 8, wherein when the folding mechanism (100) is in an unfolded state, the first point of application of force (P1) is close to the second support surface (4a) relative to the second point of application of force (P2).

10. The folding mechanism (100) according to any one of claims 1 to 9, wherein the folding mechanism (100) further comprises a first attraction member (33) and a second attraction member (34), the first attraction member (33) is fastened to the first fastening bracket (21), the second attraction member (34) is fastened to the first support plate (4), and the second attraction member (34) is located on a side that is of the first rotation axis (P1) and that is close to the main shaft (1); and
when the folding mechanism (100) is in a folded state, the second attraction member (34) and the first attraction member (33) attract each other.

11. The folding mechanism (100) according to claim 10, wherein relative to a first side surface (411) of the first support plate (4), the first rotation axis (L1) is disposed close to a second side surface (412) of the first support plate (4); and
relative to the second side surface (412) of the first support plate (4), the second attraction member (34) is disposed close to the first side surface (411) of the first support plate (4), wherein the first side surface (411) and the second side surface (412) of the first support plate (4) are disposed back to back, and the first side surface (411) of the first support plate (4) faces the main shaft (1).

12. The folding mechanism (100) according to claim 10, wherein when the folding mechanism (100) is in a folded state, a distance between the second attraction member (34) and the first attraction member (33) is a first distance, and when the folding mechanism (100) is in an unfolded state, the distance between the second attraction member (34) and the first attraction member (33) is a second distance, wherein the second distance is greater than the first distance.

13. The folding mechanism (100) according to claim 10, wherein the first fastening bracket (21) is provided with a first accommodation groove (416), and the first attraction member (33) is at least partially located in the first accommodation groove (2113); and/or the first support plate (4) is provided with a first accommodation groove (2113), and the second attraction member (34) is at least partially located in the first accommodation groove (416).

14. The folding mechanism (100) according to claim 10, wherein both the first attraction member (33) and the second attraction member (34) are magnets.

15. The folding mechanism (100) according to claim 10, wherein the folding mechanism (100) further comprises a third attraction member (37) and a fourth attraction member (38), the third attraction member (37) is fastened to the second fastening bracket (22), the fourth attraction member (38) is fastened to the second support plate (5), the axis of rotation of the second support plate (5) relative to the second fastening bracket (22) is the second rotation axis (L2), and the third attraction member (37) is located on a side that is of the second rotation axis (P1) and that is close to the main shaft (1); and
when the folding mechanism (100) is in a folded state, the third attraction member (37) and the fourth attraction member (38) attract each other.

16. The folding mechanism (100) according to any one of claims 1 to 15, wherein the first movable member (23) comprises a first rotation end (231) and a second rotation end (232), the first rotation end (231) of the first movable member (23) is rotatably connected to the main shaft (1), and the second rotation end (232) of the first movable member (23) is rotatably connected to the first fastening bracket (21).

17. The folding mechanism (100) according to claim 16, wherein the first movable member (23) comprises a connecting section (233), the connecting section (233) of the first movable member (23) connects the first rotation end (231) and the second rotation end (232) of the first movable member (23); and
the first support plate (4) is movably connected to the connecting section (233) of the first movable member (23) via a first revolute pair (35).

18. The folding mechanism (100) according to claim 17, wherein the first movable member (23) is provided with a rotating shaft hole (235), and the first support plate (4) is provided with a rotating shaft hole (431); and
the first revolute pair (35) comprises a connecting bracket (351), a first pin shaft (352), and a second pin shaft (353), the connecting bracket (351) is provided with a first pin shaft hole (354) and a second pin shaft hole (355) that are spaced from each other, the first pin shaft (352) passes through the first pin shaft hole (354) of the connecting bracket (351) and two ends are connected to and are in the rotating shaft hole (235) of the first movable member (23), the second pin shaft (353) passes through the second pin shaft hole (355) of the connecting bracket (351) and two ends are connected to and are in the rotating shaft hole (431) of the first support plate (4), and the connecting bracket (351) rotatably connects the first pin shaft (352) and the second pin shaft (353).

19. The folding mechanism (100) according to any one of claims 1 to 18, wherein when the folding mechanism (100) is in an unfolded state, the first support surface (1a) of the main shaft (1) protrudes relative to the second support surface (4a) of the first support plate (4) and the third support surface (5a) of the second support plate (5).

20. An electronic device (1000), comprising a first housing (300), a second housing (400), a flexible display (200), and the folding mechanism (100) according to any one of claims 1 to 19, wherein the first fastening bracket (21) is fastened to the first housing (300), and the second fastening bracket (22) is fastened to the second housing (400);
the flexible display (200) comprises a first display area (201), a second display area (202), and a third display area (203) that are sequentially connected, the first display area (201) is fastened to the first housing (300), and the third display area (203) is fastened to the second housing (400);
when the folding mechanism (100) is in an unfolded state, the support surface (100b) supports the second display area (202); and
when the folding mechanism (100) is in a folded state, the second display area (202) is located in the screen accommodating space (100a).
